# EUROPEAN PATENT SPECIFICATION

(11) **EP 4 386 753 B1**
(45) Date of publication and mention of the grant of the patent: **25.03.2026**
(21) Application number: 21961713.1
(22) Date of filing: 26.10.2021
(51) Int. Cl.: G11C 5/14, G11C 11/4094, G11C 11/419, G11C 7/12, G11C 11/4091, G11C 7/06

(54) **SINGLE-PORT MEMORY**
EINTORSPEICHER
MÉMOIRE À PORT UNIQUE

(43) Date of publication of application: 19.06.2024
(73) Proprietor: Huawei Technologies Co., Ltd., Shenzhen, Guangdong 518129 (CN)
(72) Inventor: CAI, Jiangzheng, Shenzhen, Guangdong 518129 (CN); CHENG, Kuan, Shenzhen, Guangdong 518129 (CN); BU, Mingen, Shenzhen, Guangdong 518129 (CN); ZHANG, Yuqing, Shenzhen, Guangdong 518129 (CN)
(74) Representative: Thun, Clemens
(86) International application number: PCT/CN2021/126524
(87) International publication number: WO 2023/070337

(56) References cited:
- CN-A- 101 110 260
- CN-A- 101 540 188
- CN-A- 110 600 067
- CN-A- 110 992 998
- US-A1- 2017 047 112
- US-A1- 2017 270 998
- GERAKIS VASILEIOS ET AL: "An Alternative Post-bond Testing Method for TSVs", 2020 9TH INTERNATIONAL CONFERENCE ON MODERN CIRCUITS AND SYSTEMS TECHNOLOGIES (MOCAST), IEEE, 7 September 2020 (2020-09-07), pages 1 - 4, XP033828338, DOI: 10.1109/MOCAST49295.2020.9200295

## Description

### TECHNICAL FIELD

This application relates to the field of storage technologies, and in particular, to a single-ended memory.

### BACKGROUND

A single-ended memory is a common memory, and includes storage units distributed in an array. In a column of storage units in the single-ended memory, a plurality of storage units are connected to a same read bit line (read bit line, RBL), and in the column of storage units, each storage unit is further connected to a read word line (read word line, RWL). In one read operation, the read bit line RBL is first set to be at a high level. When any storage unit is selected through a read word line RWL connected to the storage unit, the selected storage unit outputs storage information to the read bit line RBL. The storage information affects a level of the read bit line RBL, so that the storage information of the selected storage unit may be determined based on a level change of the read bit line RBL.

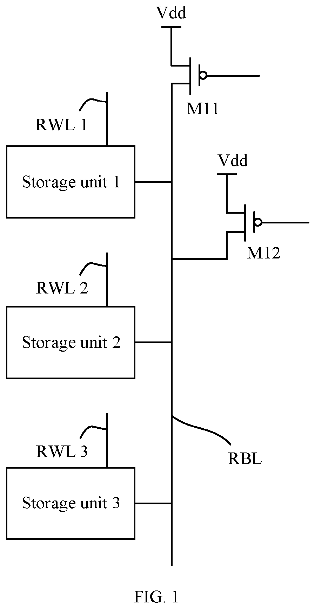

FIG. 1 is a schematic diagram of a circuit structure of a column of storage units in a single-ended memory. The single-ended memory is connected to a storage unit 1, a storage unit 2, and a storage unit 3. The storage unit 1 is further connected to a read word line RWL 1, the storage unit 2 is further connected to a read word line RWL 2, and the storage unit 3 is further connected to a read word line RWL 3. In addition, a read bit line RBL is connected to a power supply Vdd through a precharge unit (a transistor M11 is used as an example of the precharge unit in FIG. 1). The read bit line RBL is also connected to the power supply Vdd through a leakage current compensation unit (a transistor M12 is used as an example of the leakage current compensation unit in FIG. 1).

When storage information of the storage unit 1 is read, the transistor M11 is first conducted, the read bit line RBL is connected to the power supply Vdd through the transistor M11, and the power supply Vdd charges the read bit line RBL, so that the read bit line RBL changes to a high level. Subsequently, the transistor M11 is cut off and the read bit line RBL remains at the high level. The read word line RWL 1 selects the storage unit 1, and the storage unit 2 and the storage unit 3 are not selected. Therefore, the storage unit 1 outputs the storage information to the read bit line RBL. If the storage information of the storage unit 1 is the high level at this time, the storage unit 1 outputs the high level to the read bit line RBL, and the read bit line RBL remains at the high level. However, the storage unit 2 and the storage unit 3 generate a leakage current, and existence of the leakage current may decrease the level of the read bit line RBL, which may directly affect accuracy of reading the storage information of the storage unit 1. Therefore, the leakage current compensation unit (namely, the transistor M12) is introduced into circuit design of the single-ended memory, the transistor M12 is initially conducted, the read bit line RBL is connected to the power supply Vdd through the transistor M12, and the power supply Vdd charges the read bit line RBL, so that the level of the read bit line RBL increases to compensate for a level that is of the read bit line RBL and that decreases due to the leakage current, and the read bit line RBL remains at the high level. It may be accurately determined, based on the high level of the read bit line RBL, that the storage information of the storage unit 1 is the high level.

If the storage information of the storage unit 1 is a low level, the storage unit 1 outputs the low level to the read bit line RBL, and a level of the read bit line RBL starts to decrease. However, at this time, the transistor M12 is not cut off in time and is still conducted, the read bit line RBL is still connected to the power supply Vdd through the transistor M12, the power supply Vdd still charges the read bit line RBL, and the level of the read bit line RBL increases. Consequently, the level of the read bit line RBL decreases slowly. When the storage information of the storage unit 1 is determined, it is necessary to wait for the level of the read bit line RBL to change to the low level first, to accurately determine that the storage information of the storage unit 1 is the low level, thereby slowing down a read speed of the single-ended memory.
The document US 2017/270998 A1 shows a memory circuit with a reduced swing bit-line.
The document GERAKIS VASILEIOS ET AL: "An Alternative Post-Bond Testing Method for TSVs", is a scientific paper dealing with circuit testing.

### SUMMARY

The present invention is defined by the independent claims. Further advantageous developments are shown by the dependent claims.

Embodiments of this application provide a single-ended memory, and relate to the field of storage technologies, to resolve a problem of a low read speed of a conventional single-ended memory.

To achieve the foregoing objectives, the following technical solutions are provided in embodiments of this application.

### BRIEF DESCRIPTION OF DRAWINGS

FIG. 1 is a schematic diagram of a structure of a single-ended memory according to a conventional technology;
FIG. 2 is a schematic diagram of a structure of a single-ended memory according to an embodiment 1 of this application;
FIG. 3 is a schematic diagram of a structure of a typical storage unit in FIG. 2;
FIG. 4 is a schematic diagram 1 of a current flow direction of a single-ended memory according to an embodiment 2 of this application;
FIG. 5 is a schematic diagram 2 of a current flow direction of a single-ended memory according to the embodiment 2 of this application;
FIG. 6 is a schematic diagram of a structure of a single-ended memory according to an embodiment 3 of this application;
FIG. 7 is a schematic diagram of a structure of a single-ended memory according to an embodiment 4 of this application;
FIG. 8 is a schematic diagram of a structure of a single-ended memory according to an embodiment 5 of this application;
FIG. 9 is a schematic diagram of a structure of a single-ended memory according to an embodiment 6 of this application;
FIG. 10 is a schematic diagram of a structure of a single-ended memory according to an embodiment 7 of this application;
FIG. 11 is a schematic diagram of a structure of a single-ended memory according to an embodiment 8 of this application;
FIG. 12 is a schematic diagram of a structure of a single-ended memory according to an embodiment 9 of this application;
FIG. 13 is a schematic diagram of a structure of a single-ended memory according to an embodiment 10 of this application;
FIG. 14 is a schematic diagram of a structure of a single-ended memory according to an embodiment 11 of this application;
FIG. 15 is a schematic diagram of a structure of a single-ended memory according to an embodiment 12 of this application;
FIG. 16 is a performance simulation diagram 1 of a single-ended memory according to an embodiment of this application; and
FIG. 17 is a performance simulation diagram 2 of a single-ended memory according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Unless otherwise defined, all technical terms used herein have the same meaning as those commonly known to a person of ordinary skill in the art. In this application, "at least one" refers to one or more, and "a plurality of" refers to two or more. "And/or" describes an association relationship between associated objects, and represents that three relationships may exist. For example, A and/or B may represent the following cases: A exists alone, both A and B exist, and B exists alone, where A and B may be singular or plural. A character "/" usually indicates an "or" relationship between the associated objects. "At least one of the following items (pieces)" or a similar expression thereof refers to any combination of these items, including any combination of singular items (pieces) or plural items (pieces). For example, at least one item (piece) of a, b, or c may represent: a, b, c, a and b, a and c, b and c, or a, b, and c, where a, b, and c may be singular or plural. In addition, in embodiments of this application, terms such as "first" and "second" do not limit a quantity or an execution sequence.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

It should be noted that, in this application, terms such as "an example" or "for example" are used to represent giving an example, an illustration, or a description. Any embodiment or design scheme described as an "example" or "for example" in this application should not be explained as being more preferred or having more advantages than another embodiment or design scheme. Exactly, use of the word "example", "for example", or the like is intended to present a related concept in a specific manner.

The following describes technical terms in embodiments of this application.

In embodiments of this application, a metal-oxide-semiconductor field effect transistor (metal-oxide-semiconductor field effect transistor, MOSFET) may be used as a transistor, and there are two types of transistors: an N (negative)-type transistor and a P (positive, positive)-type transistor. The transistor includes a source (source), a drain (drain), and a gate (gate), and conduction or cutting off of the transistor may be controlled by controlling a level input to the gate of the transistor. When the transistor is conducted, the source and the drain are conducted to generate a turn-on current. When the transistor is cut off, the source and the drain are not conducted, but due to a structural characteristic of the transistor, a small leakage current is generated between the source and the drain. In embodiments of this application, the gate of the transistor is also referred to as a control end, the source is referred to as a first end, and the drain is referred to as a second end. Alternatively, the gate is referred to as a control end, the drain is referred to as a first end, and the source is referred to as a second end. In addition, the N-type transistor is conducted when a level of the control end is a high level, the first end and the second end are connected, and a turn-on current is generated between the first end and the second end. The N-type transistor is cut off when the level of the control end is a low level, the first end and the second end are disconnected, and a leakage current exists between the first end and the second end. The P-type transistor is conducted when the level of the control end is the low level, and the first end and the second end are connected to generate a turn-on current. The P-type transistor is cut off when the level of the control end is the high level, the first end and the second end are disconnected, and a leakage current exists.

In embodiments of this application, if storage information of a storage unit is a high level, it indicates that data currently stored in the storage unit is "1" (also referred to as a logic "1"). If the storage information of the storage unit is a low level, it indicates that data currently stored in the storage unit is "0" (also referred to as a logic "0"). In addition, the high level also indicates that a current voltage is higher than a predetermined value; and the low level also indicates that the current voltage is lower than the predetermined value (the predetermined value may change with a circuit change). In addition, that a signal is a high level indicates that the current signal is logic high (sometimes referred to as HIGH); and that a signal is a low level indicates that the current signal is logic low (sometimes referred to as LOW).

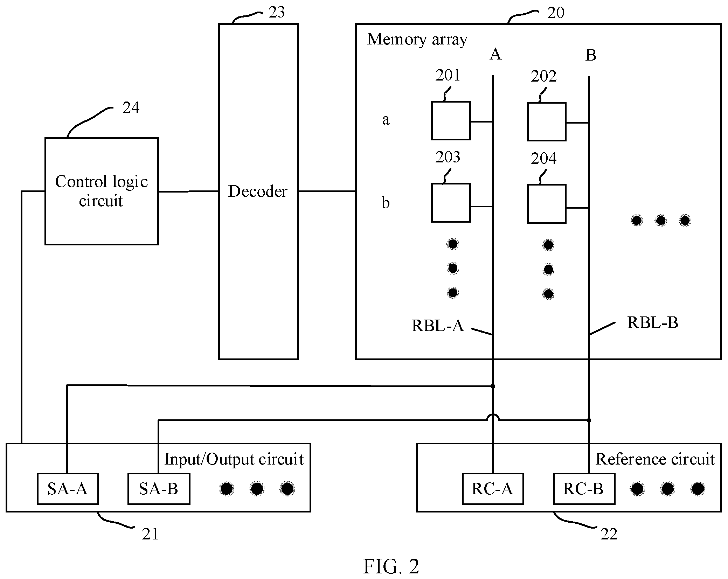

FIG. 2 is a schematic diagram of a structure of a single-ended memory according to an embodiment of this application. The single-ended memory includes a memory array 20, an input/output (input/output, I/O) circuit 21, a reference circuit 22, and a decoder 23 that are separately coupled to the memory array 20, and a control logic circuit 24 that is coupled to the input/output circuit 21 and the decoder 23.

Refer to FIG. 2. The memory array 20 includes a plurality of storage units, the plurality of storage units are distributed in an array in the memory array 20, and each storage unit includes a plurality of transistors. As shown in FIG. 2, a storage unit 201 and a storage unit 202 are arranged in an a row, and a storage unit 203 and a storage unit 204 are arranged in a b row. The storage unit 201 and the storage unit 203 are arranged in an A column, and the storage unit 202 and the storage unit 204 are arranged in a B column. Each storage unit is configured to store one bit of data, that is, data "1" or data "0". When data stored in the storage unit is "1", it may also be referred to as that storage information of the storage unit is a high level (in subsequent embodiments of this application, that the storage information of the storage unit is the high level indicates that the data stored in the storage unit is "1"). When the data stored in the storage unit is "0", it may also be referred to as that the storage information of the storage unit is a low level (in subsequent embodiments of this application, that the storage information of the storage unit is the low level indicates that the data stored in the storage unit is "0"). In addition, the memory array 20 further includes a plurality of bit lines (bit lines, BLs) (which may be read bit lines (read bit lines, RBLs) or write bit lines (write bit lines, WBLs)) and/or bit bar lines (which may be write bit bar lines (write bit bar lines, WBBLs)) arranged along corresponding columns, and a plurality of word lines (word lines, WLs) (which may be read word lines (read word lines, RWLs) or write word lines (write word lines, WWLs)) arranged along corresponding rows. For clarity, each column in FIG. 2 shows only one read bit line, for example, a read bit line RBL-A of the A column and a read bit line RBL-B of the B column shown in FIG. 2.

The input/output circuit 21 includes a plurality of sense amplifiers (sense amplifiers, SAs) (such as a sense amplifier SA-A and a sense amplifier SA-B shown in FIG. 2), and the reference circuit (reference circuit, RC) 22 includes a plurality of sub-reference circuits (such as a sub-reference circuit RC-A and a sub-reference circuit RC-B shown in FIG. 2). Each column of storage units of the memory array 20 are coupled to a corresponding sense amplifier and a sub-reference circuit through a read bit line RBL. As shown in FIG. 2, the storage unit 201, the storage unit 203, and the like of the A column are coupled to the sense amplifier SA-A and the sub-reference circuit RC-A through the read bit line RBL-A. The storage unit 202, the storage unit 204 and the like of the B column are coupled to the sense amplifier SA-B and the sub-reference circuit RC-B through the read bit line RBL-B. For example, when a corresponding column is added to the memory array 20, a sense amplifier corresponding to the column in the memory array 20 is added to the input/output circuit 21, and a sub-reference circuit corresponding to the column in the memory array 20 is added to the reference circuit 22.

The decoder 23 coupled to the memory array 20 may be configured to receive address information (for example, a row address) provided by the control logic circuit 24 to assert (assert) one or more word lines of the memory array 20. In addition, the control logic circuit 24 may be coupled to the input/output circuit 21 to retrieve data read out by the sense amplifier (for example, the sense amplifier SA-A or the sense amplifier SA-B) during a read operation.

The single-ended memory shown in FIG. 2 may alternatively include another memory array and/or another one or more functional circuits (such as a buffer circuit and a sequential circuit), and each memory array may include more or fewer storage units.

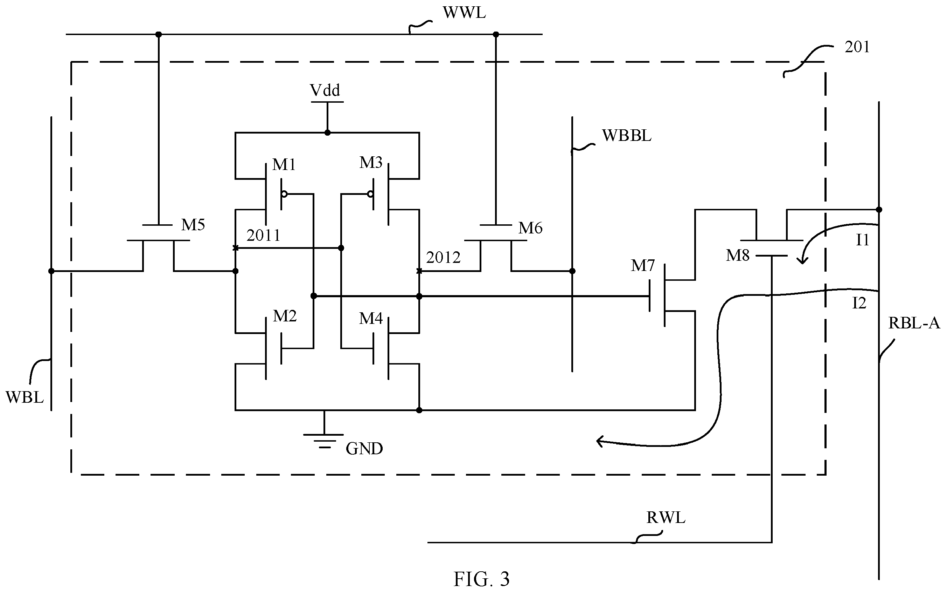

FIG. 3 is a schematic diagram of a typical structure of the storage unit 201 in FIG. 2 according to an embodiment of this application. The storage unit 201 includes eight transistors (the storage unit composed of the eight transistors is also referred to as an eight-transistor static random access storage unit), which are: a transistor M1, a transistor M2, a transistor M3, a transistor M4, a transistor M5, a transistor M6, a transistor M7, and a transistor M8. As shown in FIG. 3, the transistor M1 and the transistor M3 are P-type transistors, and the other transistors are N-type transistors. The storage unit 201 further includes a write word line WWL, a write bit line WBL, a write bit bar line WBBL, a read bit line RBL-A, and a read word line RWL.

As shown in FIG. 3, a first end of the transistor M1 is connected to a power supply Vdd, a second end of the transistor M1 is connected to a first end of the transistor M2, and a second end of the transistor M2 is connected to the ground GND. A first end of the transistor M3 is connected to the power supply Vdd, a second end of the transistor M3 is connected to a first end of the transistor M4, a second end of the transistor M4 is connected to the ground GND, the second end of the transistor M3 is further connected to a control end of the transistor M1, and the control end of the transistor M1 is further connected to a control end of the transistor M2. The write bit line WBL is connected to a first end of the transistor M5, a second end of the transistor M5 is connected to the second end of the transistor M1, the second end of the transistor M5 is further connected to a control end of the transistor M3, and the control end of the transistor M3 is further connected to a control end of the transistor M4. The write word line WWL is connected to a control end of the transistor M5, the write word line WWL is also connected to a control end of the transistor M6, a first end of the transistor M6 is connected to the second end of the transistor M3, and a second end of the transistor M6 is connected to the write bit bar line WBBL. The second end of the transistor M3 is further connected to a control end of the transistor M7, a second end of the transistor M7 is connected to the ground, a first end of the transistor M7 is connected to a first end of the transistor M8, a second end of the transistor M8 is connected to the read bit line RBL-A, and a control end of the transistor M8 is connected to the read word line RWL. The second end of the transistor M1 is further coupled to a first node 2011 in the storage unit 201, and the second end of the transistor M3 is further coupled to a second node 2012 of the storage unit 201.

The transistors M1 to M6 form a core of the storage unit 201, and the core is mainly configured to perform a write operation (in other words, the core includes a write interface). The transistor M1 and the transistor M2 are connected to form a first inverter, and the transistor M3 and the transistor M4 are connected to form a second inverter, where the first inverter and the second inverter are cross-coupled to each other (as shown in FIG. 3). Specifically, the first inverter and the second inverter are separately coupled between the power supply Vdd and the ground GND. Further, the first inverter is coupled to the transistor M5, and the second inverter is coupled to the transistor M6. The transistor M5 and the transistor M6 are also coupled to the write word line WWL of the storage unit, the transistor M5 is also coupled to the write bit line WBL, and the transistor M6 is also coupled to the write bit bar line WBBL. Conduction and cutting off of the transistor M5 and the transistor M6 are controlled by the write word line WWL. The core of the storage unit 201 makes a storage function of the storage unit 201 stable. The transistor M7 and the transistor M8 form a read buffer of the storage unit 201, and the read buffer is mainly configured to perform a read operation (in other words, the read buffer provides a read interface). The read word line RWL controls the transistor M8 to be conducted or cut off. If the read word line RWL is at a high level, it indicates that the current storage unit 201 is selected to output storage information; and if the read word line RWL is at a low level, it indicates that the current storage unit 201 is not selected. The storage information of the storage unit 201 controls the transistor M7 to be conducted or cut off. When the storage information of the storage unit 201 is the high level, the storage information being the high level controls the transistor M7 to be cut off. When the storage information of the storage unit 201 is the low level, the storage information being the low level controls the transistor M7 to be conducted.

With reference to the single-ended memory shown in FIG. 2 and the storage unit shown in FIG. 3, the following describes a process in which the single-ended memory writes storage information to the storage unit 201 and reads the storage information from the storage unit 201.

Refer to FIG. 2. When the storage information is written into the storage unit 201, the input/output circuit 21 first receives a current write instruction, and the input/output circuit 21 obtains, through the control logic circuit 24, address information (for example, a row address) of the corresponding storage unit to which the storage information needs to be written in the write instruction. Then, one or more word lines of the corresponding storage unit to which the storage information needs to be written in the memory array 20 are asserted (assert) by the decoder 23. As shown in FIG. 3, the transistor M5 and the transistor M6 are conducted when the write word line WWL is set to be at the high level. The write bit line WBL transmits corresponding storage information being the low level/high level to the storage unit 201, while the write bit bar line WBBL receives a reverse signal of the storage information (for example, when the storage information received by the WBL is the high level, the storage information received by the write bit bar line is the low level; and when the storage information received by the WBL is the low level, the storage information received by the write bit bar line is the high level). If it is assumed that the storage information currently transmitted by the write bit line WBL is the low level, the transistor M3 and the transistor M2 in the corresponding storage unit 201 are conducted, the transistor M1 and the transistor M4 are cut off, the first node 2011 in the storage unit 201 is at the low level, the second node 2012 is at the high level, and the storage information being the low level transmitted by the write bit line WBL is accurately written to the core of the storage unit 201. If it is assumed that the storage information currently transmitted by the write bit line WBL is the high level, the transistor M3 and the transistor M2 in the corresponding storage unit 201 are cut off, the transistor M1 and the transistor M4 are conducted, the first node 2011 in the storage unit 201 is at the high level, the second node 2012 is at the low level, and the storage information being the high level transmitted by the write bit line WBL is accurately written to the core of the storage unit 201. In other words, that the first node 2011 in the storage unit 201 is at the high level and the second node 2012 is at the low level indicates that the current storage information of the storage unit 201 is the high level; and that the first node 2011 in the storage unit 201 is at the low level and the second node 2012 is at the high level indicates that the storage information of the storage unit 201 is the low level.

Refer to FIG. 2. When the storage information of the storage unit 201 is read, the input/output circuit 21 first receives a current read instruction, and the input/output circuit 21 obtains, through the control logic circuit 24, address information (for example, a row address) of the corresponding storage unit from which the storage information needs to be read in the read instruction. Then, one or more word lines of the corresponding storage unit from which the storage information needs to be read in the memory array 20 are asserted (assert) by the decoder 23, and the read bit line also needs to be set to be at the high level. Refer to FIG. 3. The read word line RWL and the read bit line RBL-A are set to be at the high level. The read word line RWL is set to be at the high level so that the storage unit 201 is selected, and the transistor M8 in the storage unit 201 is conducted. At this time, a current I1 is generated between the transistor M8 and the read bit line RBL-A. If it is assumed that the storage information of the current storage unit 201 is the high level, the first node 2011 in the storage unit 201 is at the high level, the second node 2012 is at the low level, the transistor M7 is cut off, the read bit line RBL-A is not connected to the ground GND through the transistor M7 and the transistor M8, and a current I2 flowing through the transistor M7 and the transistor M8 is not generated. Therefore, the storage unit 201 outputs the high level to the read bit line RBL-A, and a level of the read bit line RBL-A remains at the initial high level. Refer to FIG. 2. The input/output circuit 21 receives the level of the read bit line RBL-A and a level of the sub-reference circuit RC-A, and determines that the level of the read bit line RBL-A is higher than the level of the sub-reference circuit RC-A. In this case, it is determined that the storage information of the storage unit 201 is the high level. Refer to FIG. 3. If it is assumed that the storage information of the current storage unit 201 is the low level, the first node 2011 in the storage unit 201 is at the low level, the second node 2012 is at the high level, the transistor M7 is conducted, the read bit line RBL-A is connected to the ground GND through the transistor M7 and the transistor M8, and a current I2 flowing through the transistor M7 and the transistor M8 is generated. Therefore, the storage unit 201 outputs the low level to the read bit line RBL-A, and the level of the read bit line RBL-A starts to decrease. Refer to FIG. 2. The input/output circuit 21 receives the level of the read bit line RBL-A and the level of the sub-reference circuit RC-A, and determines that the level of the read bit line RBL-A is less than the level of the sub-reference circuit RC-A. In this case, it is determined that the storage information of the storage unit 201 is the low level.

It should be noted that, based on a requirement of an actual single-ended memory, the reference circuit 22 may be disposed, or the reference circuit 22 may not be disposed. When the reference circuit 22 is not disposed, the input/output circuit 21 receives only the level of the read bit line, and determines, based on the level of the read bit line, whether the storage information of the current storage unit is the high level or the low level.

When storage information of the selected storage unit in the single-ended memory is read, the selected storage unit outputs the storage information to the read bit line, and the storage information affects the level of the read bit line. In this case, another storage unit that is in a same column as the selected storage unit generates a leakage current, and the leakage current also affects the level of the read bit line, resulting in an abnormal level change of the read bit line. Therefore, a leakage current compensation unit is generally disposed in the single-ended memory.

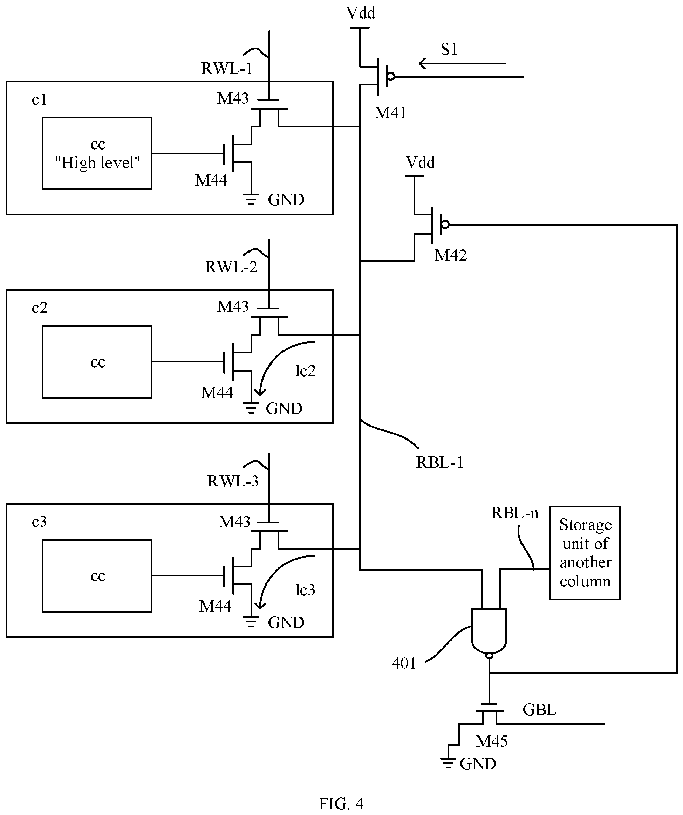

Specifically, refer to FIG. 4. An embodiment of this application provides a schematic diagram of a structure of a single-ended memory. The single-ended memory includes a read bit line RBL-1 and another read bit line RBL-n, and each read bit line includes a plurality of storage units. The read bit line RBL-1 is used as an example. Three storage units (a storage unit c1, a storage unit c2, and a storage unit c3) are connected to the read bit line RBL-1, and storage information of the three storage units can be read through the read bit line RBL-1. The storage unit c1 is further connected to a read word line RWL-1, the storage unit c2 is further connected to a read word line RWL-2, and the storage unit c3 is further connected to a read word line RWL-3. The read bit line RBL-1 is further connected to a power supply Vdd through a precharge unit (in FIG. 4, a transistor M41 is used as an example of the precharge unit, a first end of the transistor M41 is connected to the power supply Vdd, and a second end of the transistor M41 is connected to the read bit line RBL-1), and the read bit line RBL-1 is connected to the power supply Vdd through a leakage current compensation unit (in FIG. 4, a transistor M42 is used as an example of the leakage current compensation unit, a first end of the transistor M42 is connected to the power supply Vdd, and a second end of the transistor M42 is connected to the read bit line RBL-1). In addition, the read bit line RBL-1 is coupled to a first input end of a NAND gate 401, a storage unit of another column is coupled to a second input end of the NAND gate 401 through the another read bit line RBL-n, and an output end of the NAND gate 401 is coupled to a control end of a transistor M45. A first end of the transistor M45 is connected to the ground GND, a second end of the transistor M45 is connected to a global bit line (global bit line, GBL), and the output end of the NAND gate 401 is also coupled to a control end of the transistor M42. A P-type transistor is used as an example of the transistor M41 and the transistor M42, and an N-type transistor is used as an example of the transistor M45.

In addition, for a structure of the three storage units in the single-ended memory shown in FIG. 4, refer to the schematic diagram of the structure of the storage unit 201 shown in FIG. 3. A core cc in the storage unit in FIG. 4 is equivalent to the transistors M1 to M6 in the storage unit 201 in FIG. 3, and the core cc is configured to store storage information and perform a write operation. A transistor M44 in FIG. 4 is equivalent to the transistor M7 in the storage unit 201 in FIG. 3, and a core cc in each storage unit is coupled to the transistor M44. When storage information stored in the core cc of the storage unit is a high level, the transistor M44 is cut off. When the storage information stored in the core cc of the storage unit is a low level, the transistor M44 is conducted. A transistor M43 in the storage unit in FIG. 4 is equivalent to the transistor M8 in the storage unit 201 in FIG. 3. When the read word line RWL is at the high level, the transistor M43 in the storage unit is controlled to be conducted. When the read word line RWL is at the low level, the transistor M43 in the storage unit is controlled to be cut off.

As shown in FIG. 4, when the single-ended memory reads the storage information, a precharge signal S1 is first switched from a high level to a low level, to control a level of a control end of the transistor M41 to be a low level, so that the transistor M41 is conducted, the power supply Vdd is connected to the read bit line RBL-1, and the power supply Vdd charges the read bit line RBL-1. In this way, a level of the read bit line RBL-1 is the high level, and the precharge signal S1 switches from the low level to the high level, to control the level of the control end of the transistor M41 to be the high level, so that the transistor M41 is cut off, the power supply Vdd stops charging the read bit line RBL-1, and the read bit line RBL-1 remains at the high level. The another read bit line RBL-n connected to the storage unit of the another column is connected to the power supply Vdd through a switch 1, and the global bit line GBL is also connected to the power supply Vdd through a switch 2. When the precharge signal S1 switches from the high level to the low level to control the level of the read bit line RBL-1 to be the high level, the switch 1 and the switch 2 are also turned on, so that the another read bit line RBL-n and the global bit line GBL are connected to the power supply Vdd, and the another read bit line RBL-n and the global bit line GBL are also set to be at the high level. Because the transistor M45 is cut off (because high levels of the read bit line RBL-1 and the another read bit line RBL-n are output to be low levels through a NAND operation of the NAND gate 401, M45 is controlled to be cut off), the global bit line GBL remains at the high level.

A reading process of the single-ended memory is described by using reading storage information of the storage unit c1 as an example. That the read word line RWL-1 connected to the storage unit c1 is at the high level controls a level of a control end of the transistor M43 to be a high level, so that the storage unit c1 is selected, and the storage unit c1 outputs storage information to the read bit line RBL-1. That the read word line RWL-2 connected to the storage unit c2 is at the low level controls the level of the control end of the transistor M43 to be a low level, so that the storage unit c2 is not selected. That the read word line RWL-3 connected to the storage unit c3 is at the low level controls the level of the control end of the transistor M43 to be a low level, so that the storage unit c3 is not selected.

As shown in FIG. 4, if the storage information of the storage unit c1 is the high level, the storage information of the storage unit c1 controls the transistor M44 to be cut off, and the read bit line RBL-1 is not connected to the ground GND because the transistor M43 and the transistor M44 in the storage unit c1 are cut off. The level of the read bit line RBL-1 remains at the high level, which is equivalent to that the storage unit c1 outputs the high level to the read bit line RBL-1. Because the another read bit line RBL-n is set to be at the high level, the high levels of the read bit line RBL-1 and the another read bit line RBL-n are output to be the low levels by the NAND operation of the NAND gate 401. The low levels are transmitted to a control end of the leakage current compensation unit (namely, the transistor M42), so that the transistor M42 is conducted, the read bit line RBL-1 is connected to the power supply Vdd through the transistor M42, and the power supply Vdd charges the read bit line RBL-1. In addition, the output end of the NAND gate 401 outputs the low level, and the transistor M45 is also controlled to be cut off, so that the global bit line GBL is not connected to the ground through the transistor M45. Therefore, an input/output circuit coupled to the global bit line GBL may determine that a level of the global bit line GBL is the high level, and may also determine that the storage information of the currently selected storage unit c1 is the high level. The transistor M43 and the transistor M44 in the storage unit c2 generate a leakage current. In other words, as shown in FIG. 4, the read bit line RBL-1 is connected to the ground GND through the transistor M43 and the transistor M44 in the storage unit c2, and the storage unit c2 generates a leakage current Ic2 flowing through the transistor M43 and the transistor M44. The read bit line RBL-1 is also connected to ground GND through the transistor M43 and the transistor M44 in the storage unit c3, and the storage unit c3 generates a leakage current Ic3 flowing through the transistor M43 and the transistor M44. The leakage current Ic2 and the leakage current Ic3 cause the level of the read bit line RBL-1 to decrease. However, because the leakage current compensation unit (namely, the transistor M42) is disposed in the single-ended memory, the transistor M42 is conducted so that the read bit line RBL-1 is connected to the power supply Vdd through the transistor M42, and the level of the read bit line RBL-1 increases. This compensates for the level that is of the read bit line RBL-1 and that decreases due to generation of the leakage current Ic2 and the leakage current Ic3.

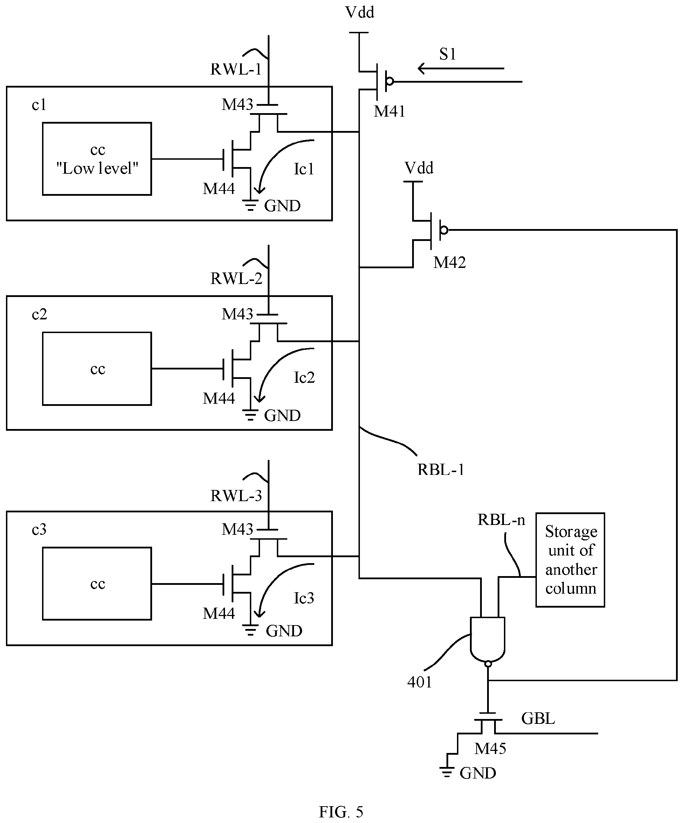

As shown in FIG. 5, if the storage information of the storage unit c1 is the low level, the storage information of the storage unit c1 controls the transistor M44 to be conducted, the read bit line RBL-1 is connected to the ground GND because the transistor M43 and the transistor M44 in the storage unit c1 are conducted, and the storage unit c1 generates a turn-on current Ic1 flowing through the transistor M43 and the transistor M44. The storage unit c1 outputs the low level to the read bit line RBL-1. and the level of the read bit line RBL-1 starts to decrease. When the level of the read bit line RBL-1 decreases to the low level, the NAND gate 401 performs the NAND operation on the levels of the read bit line RBL-1 and the another read bit line RBL-n, outputs the high level to the transistor M45, and the transistor M45 is conducted. In this way, the global bit line GBL is connected to the ground GND through the transistor M45, and the level of the global bit line GBL starts to decrease. When the level of the global bit line GBL gradually decreases to the low level, the input/output circuit coupled to the global bit line GBL may determine that the storage information of the storage unit c1 is the low level. At the same time, when the NAND gate 401 outputs the high level, the control end of the transistor M42 can also receive the high level, the transistor M42 is cut off, and the power supply Vdd stops charging the read bit line RBL-1. However, when the level of the read bit line RBL-1 starts to decrease until the level of the read bit line RBL-1 decreases to the low level, the transistor M42 keeps being conducted, and the power supply Vdd charges the read bit line RBL-1. This affects a level decrease speed of the read bit line RBL-1, and slows down a read speed of the single-ended memory.

It should be noted that the single-ended memory may further include a leakage current compensation unit, a precharge unit, and a NAND gate that are in a one-to-one correspondence with the another read bit line RBL-n. When storage information of a storage unit connected to one read bit line is read, a leakage current compensation unit, a precharge unit, and a NAND gate that are corresponding to the read bit line work. Alternatively, the single-ended memory may further include a leakage current compensation unit and a precharge unit that are in a one-to-one correspondence with the another read bit line RBL-n, and a control end of each leakage current compensation unit is connected to the output end of the NAND gate 401 through a switch. When storage information of a storage unit connected to one read bit line is read, a switch connected to a leakage current compensation unit corresponding to the one read bit line is turned on, and the leakage current compensation unit corresponding to the one read bit line works.

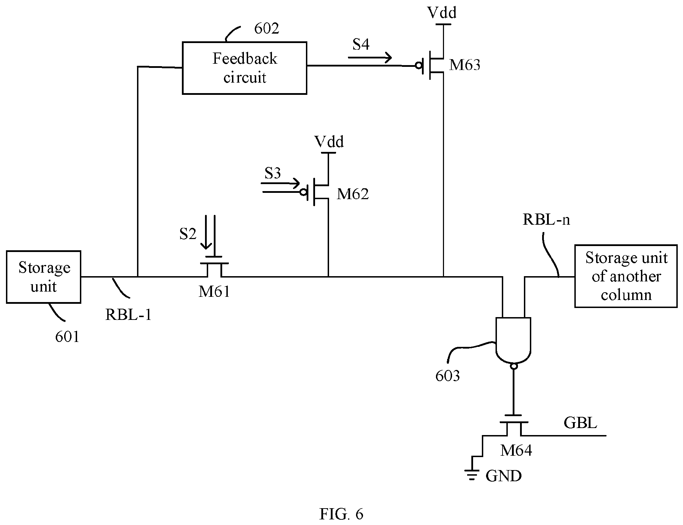

To resolve a problem of a slow read speed of the single-ended memory, an embodiment of this application provides a single-ended memory. The single-ended memory may be applied to the memory array 20 shown in FIG. 2. FIG. 6 is a schematic diagram of a structure of a single-ended memory according to an embodiment of this application. The single-ended memory includes a storage unit 601 distributed in an array, and the storage unit 601 is connected to the read bit line RBL-1 and a read word line. The read bit line RBL-1 is connected to a precharge unit (a transistor M62 is used as an example of the precharge unit in FIG. 6) through a column selection unit (a transistor M61 is used as an example of the column selection unit in FIG. 6). The read bit line RBL-1 is connected to an output end of a leakage current compensation unit (a transistor M63 as is used as an example of the leakage current compensation unit in FIG. 6) through the column selection unit. The read bit line RBL-1 is further connected to a control end of the leakage current compensation unit through a feedback circuit 602. When determining that a level of the read bit line is lower than a first predetermined value, the feedback circuit 602 outputs a feedback (feedback) signal to the control end of the leakage current compensation unit, to stop the leakage current compensation unit from charging the read bit line RBL-1 through the output end.

Refer to FIG. 6. In an example, the column selection unit of the single-ended memory includes the transistor M61, the precharge unit includes the transistor M62, and the leakage current compensation unit includes the transistor M63. The read bit line RBL-1 is connected to the storage unit 601. The power supply Vdd is connected to a first end of the transistor M62, a second end of the transistor M62 is connected to a second end of the transistor M61, and a first end of the transistor M61 is connected to the read bit line RBL-1. The read bit line RBL-1 is connected to a control end of the transistor M63 through the feedback circuit 602, the feedback circuit 602 is connected to a transmission path between the storage unit 601 and the transistor M61, a first end of the transistor M63 is connected to the power supply Vdd, and a second end of the transistor M63 is connected to the second end of the transistor M61. The read bit line RBL-1 is coupled to a first input end of a NAND gate 603, a storage unit of another column is coupled to a second input end of the NAND gate 603 through another read bit line RBL-n, an output end of the NAND gate 603 is connected to a control end of a transistor M64, a first end of the transistor M64 is connected to the ground GND, and a second end of the transistor M64 is connected to a global bit line GBL.

It should be noted that the column selection unit, the precharge unit, and the leakage current compensation unit may also include more or fewer other electronic components, and a connection relationship between the column selection unit, the precharge unit, and the leakage current compensation unit may also be simpler or more complex. The read bit line RBL-1 may also be connected to more storage units.

As shown in FIG. 6, when the single-ended memory reads storage information of the storage unit 601, because the storage unit 601 is connected to the read bit line RBL-1, a column selection signal S2 needs to be first changed from a low level to a high level, to control the transistor M61 to be conducted, indicating that the read bit line RBL-1 is selected. Then, a precharge signal S3 changes from the high level to the low level, to control the transistor M62 to be conducted, so that the read bit line RBL-1 is connected to the power supply Vdd through the transistor M61 and the transistor M62, the power supply Vdd charges the read bit line RBL-1, and the read bit line RBL-1 is at the high level. Subsequently, the precharge signal S3 changes from the low level to the high level, to control the transistor M62 to be cut off, so that the power supply Vdd stops charging the read bit line RBL-1, and the read bit line RBL-1 remains at the high level. The another read bit line RBL-n connected to the storage unit of the another column is set to be at the high level, and the global bit line GBL is also set to be at the high level in advance (For details, refer to steps in which the another read bit line RBL-n and the global bit line GBL are set to be at the high level shown in FIG. 4). Because the transistor M64 is cut off (because high levels of the read bit line RBL-1 and the another read bit line RBL-n are output to be low levels by a NAND operation of the NAND gate 603, M64 is controlled to be cut off), the global bit line GBL remains at the high level.

Next, the read word line selects the storage unit 601, and the storage unit 601 outputs the storage information to the read bit line RBL-1.

When the storage information of the storage unit 601 is the low level (for example, as shown in FIG. 5, the transistor M44 in the storage unit c1 is conducted, and the storage unit c1 outputs the low level to the read bit line RBL-1, where the storage unit 601 is the same as the storage unit c1), a level of the read bit line RBL-1 starts to decrease. In this case, after determining that the level of the read bit line RBL-1 decreases to the first predetermined value, the feedback circuit 602 outputs a feedback signal S4 to the control end of the transistor M63, to control the transistor M63 to be cut off (for example, when the transistor M63 is a P-type transistor, the feedback signal S4 is the high level; and when the transistor M63 is an N-type transistor, the feedback signal S4 is the low level), so that the transistor M63 disconnects the read bit line RBL-1 from the power supply Vdd, the power supply Vdd stops charging the read bit line RBL-1, and the level of the read bit line RBL-1 decreases to the low level. If the level of the read bit line RBL-1 is the low level, and the another read bit line RBL-n always remains at the high level, the NAND gate 603 performs NAND processing, and the output end of the NAND gate 603 outputs the high level, to control the transistor M64 to be conducted, so that the global bit line GBL is connected to the ground GND through the transistor M64, and a level of the global bit line GBL gradually decreases to the low level. An input/output circuit coupled to the global bit line GBL may determine that the level of the global bit line GBL is the low level, and may also determine that the storage information of the currently selected storage unit 601 is the low level.

In the foregoing single-ended memory, when the column selection unit selects the read bit line, the precharge unit charges the read bit line through the column selection unit, and the read bit line remains at the high level. If the read word line selects a storage unit at this time, the storage unit outputs storage information to the read bit line. When the storage information is a low level, a level of the read bit line starts to decrease, and the feedback circuit outputs the feedback signal to the control end of the leakage current compensation unit after determining that the level of the read bit line is lower than a predetermined value. The feedback signal may stop the leakage current compensation unit from charging the read bit line through the output end. The leakage current compensation unit of the single-ended memory is controlled by the feedback signal output by the feedback circuit, and the feedback signal output by the feedback circuit changes in time based on a level change of the read bit line, so that the leakage current compensation unit can be turned off in time. Because the leakage current compensation unit stops charging the read bit line in time, the level of the read bit line can decrease more quickly under effect of the storage information being the low level. In this case, the single-ended memory can read the storage information on the read bit line more quickly and a read speed of the single-ended memory becomes faster.

Still refer to FIG. 6. When the storage information of the storage unit 601 is the high level (for example, as shown in FIG. 4, the transistor M44 in the storage unit c1 is cut off, and the storage unit c1 outputs the high level to the read bit line RBL-1, where the storage unit 601 is the same as the storage unit c1), the read bit line RBL-1 remains at the high level. However, a leakage current is generated by another unselected storage unit that is connected to the current read bit line RBL-1. In this case, when determining that the level of the read bit line RBL-1 is higher than a second predetermined value, the feedback circuit 602 connected to the read bit line RBL-1 outputs the feedback signal S4 to the control end of the transistor M63, to control the transistor M63 to be conducted (for example, when the transistor M63 is the P-type transistor, the feedback signal S4 is the low level; and when the transistor M63 is the N-type transistor, the feedback signal S4 is the high level), so that the read bit line RBL-1 is connected to the power supply Vdd through the transistor M63 and the transistor M61, the power supply Vdd charges the read bit line RBL-1 to compensate for the leakage current generated by the unselected storage unit on the read bit line RBL-1, and the read bit line RBL-1 remains at the high level. Because the another read bit line RBL-n always remains at the high level, the NAND gate 603 performs NAND processing, and the output end of the NAND gate 603 outputs the low level, to control the transistor M64 to be cut off, so that the global bit line GBL is not connected to the ground GND through the transistor M64, and the level of the global bit line GBL remains at the initial high level. The input/output circuit coupled to the global bit line GBL may determine that the level of the global bit line GBL is the high level, and may also determine that the storage information of the currently selected storage unit 601 is the high level.

The first predetermined value is less than or equal to the second predetermined value. Specifically, the first predetermined value further needs to be higher than the low level. Only when the first predetermined value is higher than the low level, the feedback circuit 602 can output the feedback signal to the transistor M63 before the level of the read bit line RBL-1 decreases to the low level, to stop the power supply Vdd from charging the read bit line RBL-1 through the transistor M63. The second predetermined value further needs to be less than the high level. Only when the second predetermined value is less than the high level, the feedback circuit 602 can output the feedback signal to the transistor M63 when the level of the read bit line RBL-1 decreases due to generation of the leakage current, to control the power supply Vdd to charge the read bit line RBL-1 through the transistor M63.

In the foregoing single-ended memory, when the storage information of the selected storage unit is the high level, the read bit line remains at the high level. When determining that the level of the read bit line is higher than the second predetermined value, the feedback circuit outputs the feedback signal to the control end of the leakage current compensation unit. The feedback signal may control the leakage current compensation unit to charge the read bit line through the output end, to compensate for a leakage current generated by another storage unit on the read bit line. Because the feedback signal output by the feedback circuit can also control the leakage current compensation unit to be turned on in time, read performance of the single-ended memory reading the storage information being the high level can also be ensured.

For example, the feedback circuit includes an inverter. An input end of the inverter is connected to the read bit line, and an output end of the inverter is connected to the control end of the leakage current compensation unit, where the inverter is configured to generate a feedback signal based on the level of the read bit line, to control the leakage current compensation unit to be turned on or turned off in time.

Specifically, the inverter in the feedback circuit 602 includes a first transistor and a second transistor (the inverter is also referred to as a skewed inverter).

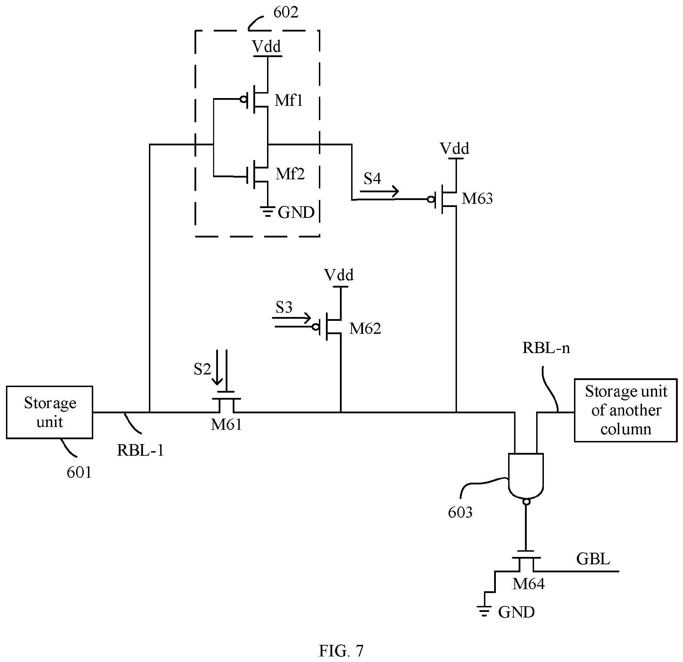

Refer to FIG. 7. An embodiment of this application provides a schematic diagram of a structure of a single-ended memory. A specific structure of the inverter in the feedback circuit 602 is shown in detail in the single-ended memory shown in FIG. 7. The inverter in the feedback circuit 602 shown in FIG. 7 includes a transistor Mf1 (namely, the foregoing first transistor, where a P-type transistor is used as an example of the transistor Mf1) and a transistor Mf2 (namely, the foregoing second transistor, where an N-type transistor is used as an example of the transistor Mf2). A first end of the transistor Mf1 is connected to a power supply Vdd, a second end of the transistor Mf1 is connected to a first end of the transistor Mf2, a second end of the transistor Mf2 is connected to the ground GND, a control end of the transistor Mf1 and a control end of the transistor Mf2 are connected to an input end of the inverter included in the feedback circuit 602, and the second end of the transistor Mf1 is further connected to an output end of the inverter included in the feedback circuit 602.

When the single-ended memory reads storage information of a storage unit 601, the storage information is a high level, and the storage unit 601 outputs the high level to a read bit line RBL-1. Although a level of the read bit line RBL-1 decreases due to a leakage current, when the level of the read bit line RBL-1 is between a second predetermined value and the high level, a level of the input end of the inverter included in the feedback circuit 602 is considered to be the high level. In this case, a level of the control end of the transistor Mf1 is the high level, and the transistor Mf1 is cut off; and a level of the control end of the transistor Mf2 is high, and the transistor Mf2 is conducted. Because the transistor Mf1 is cut off, the transistor Mf2 is conducted, and the output end of the inverter is connected to the ground GND, a level output by the output end of the inverter is the low level. In this case, a feedback signal S4 output by the feedback circuit 602 to a control end of a leakage current compensation unit (namely, the transistor M63, where the P-type transistor is used as an example of the transistor M63) is the low level, to control the transistor M63 to be conducted, so that the read bit line RBL-1 is connected to the power supply Vdd through the transistor M63, the power supply Vdd charges the read bit line RBL-1, and the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to a first predetermined value, the level of the input end of the inverter included in the feedback circuit 602 is considered to be the low level. In this case, the level of the control end of the transistor Mf1 is the low level, and the transistor Mf1 is conducted; and the level of the control end of the transistor Mf2 is the low level, and the transistor Mf2 is cut off. Because the transistor Mf1 is conducted, the transistor Mf2 is cut off, and the output end of the inverter is connected to the power supply Vdd, the level output by the output end of the inverter is the high level. In this case, the feedback signal S4 output by the feedback circuit 602 to the control end of the leakage current compensation unit (namely, the transistor M63, where the P-type transistor is used as the example of the transistor M63) is the high level, to control the transistor M63 to be cut off, so that the read bit line RBL-1 is not connected to the power supply Vdd through the transistor M63, the power supply Vdd does not charge the read bit line RBL-1, and the read bit line RBL-1 continuously decreases to the low level.

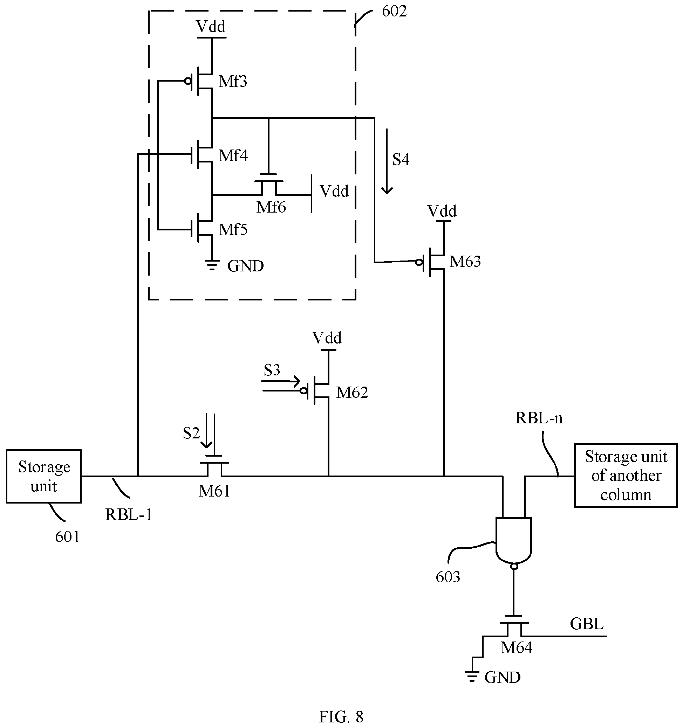

In some embodiments, FIG. 8 is a schematic diagram of a structure of a single-ended memory according to an embodiment of this application. Another specific structure of the inverter in the feedback circuit 602 is shown in detail in the single-ended memory shown in FIG. 8. The inverter in the feedback circuit 602 includes a third transistor, a fourth transistor, a fifth transistor, and a sixth transistor (the inverter is also referred to as a half-Schmitt-trigger inverter).

Specifically, as shown in FIG. 8, the inverter in the feedback circuit 602 includes a transistor Mf3 (namely, the foregoing third transistor, where a P-type transistor is used as an example of the transistor Mf3), a transistor Mf4 (namely, the foregoing fourth transistor, where an N-type transistor is used as an example of the transistor Mf4), a transistor Mf5 (namely, the foregoing fifth transistor, where the N-type transistor is used as an example of the transistor Mf5), and a transistor Mf6 (namely, the foregoing sixth transistor, where the N-type transistor is used as an example of the transistor Mf6). A first end of the transistor Mf3 is connected to a power supply Vdd, a second end of the transistor Mf3 is connected to a first end of the transistor Mf4, and a second end of the transistor Mf4 is connected to a first end of the transistor Mf5, a second end of the transistor Mf5 is connected to the ground GND, a first end of the transistor Mf6 is connected to the second end of the transistor Mf4, a control end of the transistor Mf6 is connected to the second end of the transistor Mf3, a second end of the transistor Mf6 is connected to the power supply Vdd, a control end of the transistor Mf3, a control end of the transistor Mf4, and a control end of the transistor Mf5 are connected to an input end of the inverter included in the feedback circuit 602, and the second end of the transistor Mf3 is further connected to an output end of the inverter included in the feedback circuit 602.

When the single-ended memory reads the storage information of the storage unit 601, the storage information is the high level, and the storage unit 601 outputs the high level to the read bit line RBL-1. Although the level of the read bit line RBL-1 decreases due to the leakage current, when the level of the read bit line RBL-1 is between the second predetermined value (the second predetermined value may be a positive threshold voltage of the half-Schmitt-trigger inverter) and the high level, the level of the input end of the inverter included in the feedback circuit 602 is considered to be the high level. In this case, a level of the control end of the transistor Mf3 is the high level, and the transistor Mf3 is cut off; and a level of the control end of the transistor Mf4 is the high level, a level of the control end of the transistor Mf5 is the high level, and the transistor Mf4 and the transistor Mf5 are conducted. Because the transistor Mf3 is cut off and the transistor Mf4 and the transistor Mf5 are conducted, the second end of the transistor Mf3 is connected to the ground GND, and a level of the second end of the transistor Mf3 is the low level. A level of the control end that is of the transistor Mf6 and that is connected to the second end of the transistor Mf3 is also the low level, and the transistor Mf6 is cut off. In this case, the level output by the output end of the inverter is the low level, and the feedback signal S4 output by the feedback circuit 602 to the control end of the leakage current compensation unit (namely, the transistor M63, where the P-type transistor is used as the example of the transistor M63) is the low level, to control the transistor M63 to be conducted, so that the read bit line RBL-1 is connected to the power supply Vdd through the transistor M63, the power supply Vdd charges the read bit line RBL-1, and the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value (the first predetermined value may be a negative threshold voltage of the half-Schmitt-trigger inverter), the level of the input end of the inverter included in the feedback circuit 602 is considered to be the low level. In this case, the level of the control end of the transistor Mf3 is the low level, and the transistor Mf3 is conducted; and when the level of the control end of the transistor Mf4 is the low level and the level of the control end of the transistor Mf5 is the low level, the transistor Mf4 and the transistor Mf5 are cut off. Because the transistor Mf3 is conducted and the transistor Mf4 and the transistor Mf5 are cut off, the second end of the transistor Mf3 is connected to the power supply Vdd, and the level of the second end of the transistor Mf3 is the high level. The level of the control end that is of the transistor Mf6 and that is connected to the second end of the transistor Mf3 is the high level, the transistor Mf6 is conducted, and the second end of the transistor Mf4 is also connected to the power supply Vdd through the transistor Mf6, so that the second end of the transistor Mf3 remains at the high level. Therefore, the level output by the output end of the inverter is the high level, and the feedback signal S4 output by the feedback circuit 602 to the control end of the leakage current compensation unit (namely, the transistor M63, where the P-type transistor is used as the example of the transistor M63) is the high level, to control the transistor M63 to be cut off, so that the read bit line RBL-1 cannot be connected to the power supply Vdd through the transistor M63, the power supply Vdd does not charge the read bit line RBL-1, and the level of the read bit line RBL-1 continuously decreases to the low level.

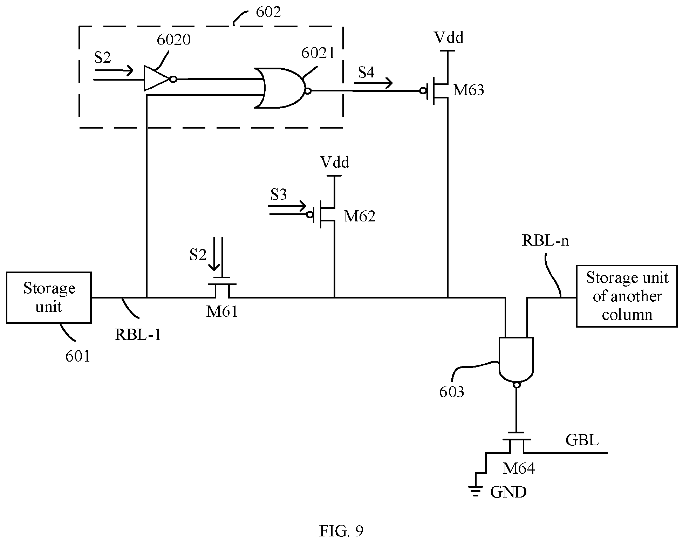

Alternatively, the feedback circuit 602 may generate the feedback signal based on the level of the read bit line by disposing a logic gate circuit. FIG. 9 is a schematic diagram of a structure of a single-ended memory according to an embodiment of this application. In the single-ended memory shown in FIG. 9, the feedback circuit 602 includes a first NOR gate and a first NOT gate.

Specifically, as shown in FIG. 9, the feedback circuit 602 of the single-ended memory includes a NOT gate 6020 (namely, the foregoing first NOT gate) and a NOR gate 6021 (namely, the foregoing first NOR gate), where an input end of the NOT gate 6020 is connected to a control end of the transistor M61 (namely, the foregoing column selection unit, where the N-type transistor is used as an example of the transistor M61), an output end of the NOT gate 6020 is connected to a first input end of the NOR gate 6021, a second input end of the NOR gate 6021 is connected to the read bit line RBL-1, and an output end of the NOR gate 6021 is connected to the control end of the leakage current compensation unit (namely, the transistor M63. where the P-type transistor is used as an example of the transistor M63).

For example, as shown in FIG. 9, the input end of the NOT gate 6020 is connected to a control end of the column selection unit. Specifically, it indicates that the column selection signal S2 is input to the control end of the transistor M61, and the column selection signal S2 is also input to the input end of the NOT gate 6020.

When the single-ended memory reads the storage information of the storage unit 601, the storage information is the high level, and the storage unit 601 outputs the high level to the read bit line RBL-1. Although the level of the read bit line RBL-1 decreases due to the leakage current, when the level of the read bit line RBL-1 is between the second predetermined value and the high level, a level input to the second input end of the NOR gate 6021 included in the feedback circuit 602 is considered to be the high level. Because the column selection signal S2 is the high level when data reading occurs, the level of the column selection signal S2 output to the first input end of the NOR gate 6021 through the NOT gate 6020 is the low level, and the NOR gate 6021 performs a NOR operation, so that the output end of the NOR gate 6021 is at the low level. In this case, the feedback signal S4 output by the feedback circuit 602 to the control end of the transistor M63 is the low level, the transistor M63 is conducted, the read bit line RBL-1 is connected to the power supply Vdd through the transistor M63, the power supply Vdd charges the read bit line RBL-1, and the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value, the level input to the second input end of the NOR gate 6021 included in the feedback circuit 602 is considered to be the low level. Because the column selection signal S2 is the high level when data reading occurs, the level of the column selection signal S2 output to the first input end of the NOR gate 6021 through the NOT gate 6020 is the low level, and the NOR gate 6021 performs the NOR operation, so that the output end of the NOR gate 6021 is at the high level. In this case, the feedback signal S4 output by the feedback circuit 602 to the control end of the transistor M63 is the high level, the transistor M63 is cut off, the read bit line RBL-1 is not connected to the power supply Vdd through the transistor M63, the power supply Vdd no longer charges the read bit line RBL-1, and the level of the read bit line RBL-1 continuously decreases to the low level.

In some other embodiments, the leakage current compensation unit of the single-ended memory may be connected to the read bit line through a first switch unit, and a control end of the first switch unit is connected to the control end of the column selection unit.

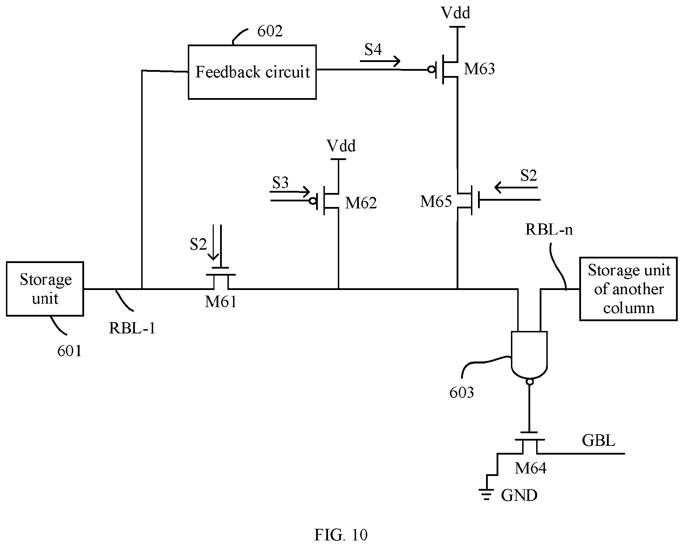

Specifically, FIG. 10 is a schematic diagram of a structure of a single-ended memory according to an embodiment of this application. The single-ended memory further includes a transistor M65 (namely, the foregoing first switch unit, where an N-type transistor is used as an example of the transistor M65). A first end of the transistor M65 is connected to the second end of the transistor M63 (namely, the foregoing leakage current compensation unit, where a P-type transistor is used as an example of the transistor M63), the first end of the transistor M63 is connected to the power supply Vdd, a second end of the transistor M65 is connected to the second end of the transistor M61 (namely, the foregoing column selection unit, where the N-type transistor is used as the example of the transistor M61), and the first end of the transistor M61 is connected to the read bit line RBL-1. That the control end of the first switch unit is connected to the control end of the column selection unit indicates that the column selection signal S2 is input to the control end of the column selection unit, and the column selection signal S2 is also input to the control end of the transistor M65. When the single-ended memory reads the storage information of the storage unit 601, the column selection signal S2 is set to the high level. Therefore, the control ends of the transistor M61 and the transistor M65 are at the high level, the transistor M61 and the transistor M65 are conducted, and the power supply Vdd is connected to the read bit line RBL-1 through the transistor M61, the transistor M65, and the transistor M63. Because a signal of the control end of the column selection unit also controls turning on or turning off of the first switch unit, it is ensured that when the column selection unit is turned on by the signal of the control end of the column selection unit to select the read bit line, the first switch unit can be simultaneously turned on to connect the leakage current compensation unit to the read bit line, so that the leakage current compensation unit can compensate for or stop compensating for the level of the read bit line in time when the read bit line is selected, and the leakage current compensation unit can work adaptively when the read bit line is selected.

For example, to enable a speed at which the single-ended memory reads the storage information being the low level fast, an embodiment of this application provides a single-ended memory. The single-ended memory further includes a discharge unit, where a control end of the discharge unit is connected to the control end of the leakage current compensation unit, a first end of the discharge unit is connected to the read bit line through the column selection unit, and a second end of the discharge unit is connected to the ground.

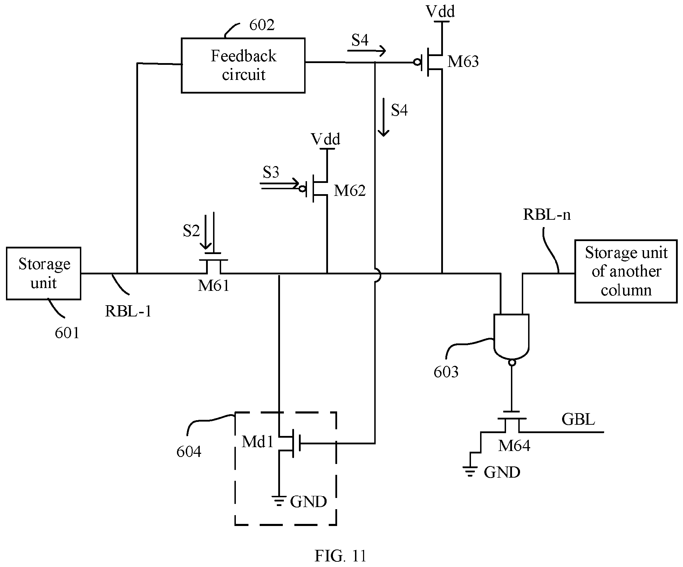

Specifically, FIG. 11 is a schematic diagram of a structure of a single-ended memory according to an embodiment of this application. The single-ended memory further includes a discharge unit 604, and the discharge unit 604 includes a transistor Md1 (an N-type transistor is used as an example of the transistor Md1). A control end of the transistor Md1 is connected to the control end of the leakage current compensation unit (namely, the transistor M63, where a P-type transistor is used as an example of the transistor M63), a second end of the transistor Md1 is connected to the ground GND, a first end of the transistor Md1 is connected to the second end of the transistor M61 (namely, the foregoing column selection unit, where the N-type transistor is used as the example of the transistor M61), and the first end of the transistor M61 is connected to the read bit line RBL-1.

When the single-ended memory reads the storage information of the storage unit 601, the storage information is the high level, and the storage unit 601 outputs the high level to the read bit line RBL-1. When determining that the level of the read bit line RBL-1 is higher than the second predetermined value, the feedback circuit 602 outputs the feedback signal S4 to the control end of the transistor M63, where the feedback signal S4 is the low level, and the transistor M63 is conducted to control the power supply Vdd to charge the read bit line RBL-1 through the transistor M63, so that the read bit line RBL-1 remains at the high level. At the same time, the control end of the transistor Md1 also receives the feedback signal S4. Because the feedback signal S4 is the low level, the transistor Md1 is cut off, and the read bit line RBL-1 is not connected to the ground GND through the transistor Md1, to ensure that the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value, the feedback circuit 602 outputs the feedback signal S4 to the control end of the transistor M63, where the feedback signal S4 is the high level, and the transistor M63 is cut off, to stop the power supply Vdd from charging the read bit line RBL-1 through the transistor M63, so that the level of the read bit line RBL-1 continuously decreases to the low level. At the same time, the control end of the transistor Md1 also receives the feedback signal S4. Because the feedback signal S4 is the high level, the transistor Md1 is conducted, the read bit line RBL-1 is connected to the ground GND through the transistor Md 1, the level of the read bit line RBL-1 decreases, and the transistor Md1 enables the level of the read bit line RBL-1 to decrease faster. The single-ended memory ensures, based on cooperation of the transistor M63 and the transistor Md1, that the level of the read bit line RBL-1 decreases to the low level as soon as possible when the storage information is the low level, to improve a read speed of the single-ended memory.

In some embodiments, to avoid a problem in which a data reading error occurs because the discharge unit is excessively responsive and connects the read bit line to the ground to perform discharge when the level of the read bit line decreases due to generation of the leakage current, an embodiment of this application further provides a discharge unit of the single-ended memory. The discharge unit of the single-ended memory includes a seventh transistor and an eighth transistor.

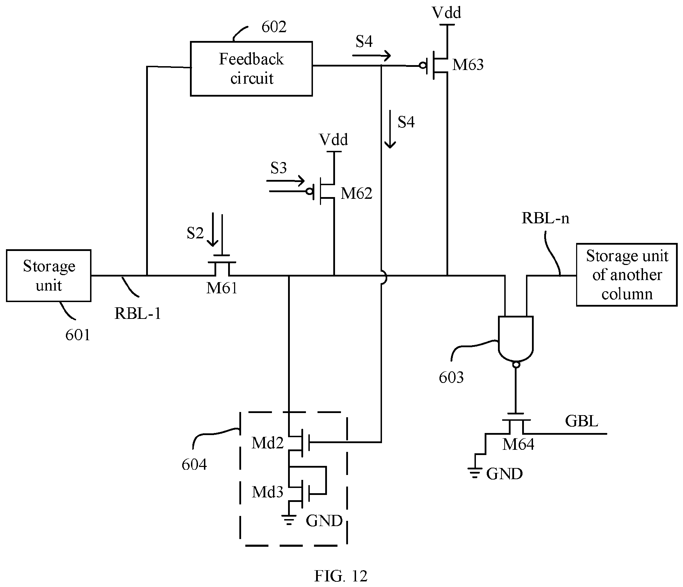

Specifically, FIG. 12 is a schematic diagram of a structure of a single-ended memory according to an embodiment of this application. A specific structure of a discharge unit 604 is shown in the single-ended memory shown in FIG. 12. The discharge unit 604 includes a transistor Md2 (namely, the foregoing seventh transistor, where an N-type transistor is used as an example of the transistor Md2) and a transistor Md3 (namely, the foregoing eighth transistor, where the N-type transistor is used as an example of the transistor Md3). A control end of the transistor Md2 is connected to the control end of the transistor M63 (namely, the foregoing leakage current compensation unit, where the P-type transistor is used as the example of the transistor M63), a first end of the transistor Md2 is connected to the second end of the transistor M61 (namely, the foregoing column selection unit, where the N-type transistor is used as the example of the transistor M61), the first end of the transistor M61 is connected to the read bit line RBL-1, a second end of the transistor Md2 is connected to a control end of the transistor Md3, the second end of the transistor Md2 is further connected to a first end of the transistor Md3, and a second end of the transistor Md3 is connected to the ground.

When the single-ended memory reads the storage information of the storage unit 601, the storage information is the high level, and the storage unit 601 outputs the high level to the read bit line RBL-1. When determining that the level of the read bit line RBL-1 is higher than the second predetermined value, the feedback circuit 602 outputs the feedback signal S4 to the control end of the transistor M63, where the feedback signal S4 is the low level, and the transistor M63 is conducted to control the power supply Vdd to charge the read bit line RBL-1 through the transistor M63, so that the read bit line RBL-1 remains at the high level. At the same time, the control end of the transistor Md2 also receives the feedback signal S4. Because the feedback signal S4 is the low level, the transistor Md2 is cut off. Because the second end of the transistor Md2 is connected to the control end of the transistor Md3, the transistor Md3 is also cut off, and the read bit line RBL-1 is not connected to the ground GND through transistor Md2 and transistor Md3, to ensure that the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value, the feedback circuit 602 outputs the feedback signal S4 to the control end of the transistor M63, where the feedback signal S4 is the high level, and the transistor M63 is cut off, to stop the power supply Vdd from charging the read bit line RBL-1 through the transistor M63, so that the level of the read bit line RBL-1 continuously decreases to the low level. At the same time, the control end of the transistor Md2 also receives the feedback signal S4. Because the feedback signal S4 is the high level, the transistor Md2 is conducted. Because the second end of the transistor Md2 is connected to the control end and the first end of the transistor Md3, and the second end of the transistor Md3 is connected to the ground GND, it is proved that the discharge unit 604 is connected to the ground GND through the transistor Md2 and the transistor Md3. When the transistor Md2 is connected to the transistor Md3 in such a manner, equivalent resistance of the current discharge unit 604 becomes larger, and a discharge speed of the discharge unit 604 becomes slower. If the level of the current read bit line RBL-1 decreases due to the leakage current, the discharge unit 604 disposed in this manner does not directly connect the read bit line RBL-1 to the ground, so that a problem in which an error occurs in reading the storage information is avoided, and therefore the read performance of the single-ended memory is more stable.

In some other embodiments, the single-ended memory includes a second NOT gate, and the discharge unit includes a ninth transistor.

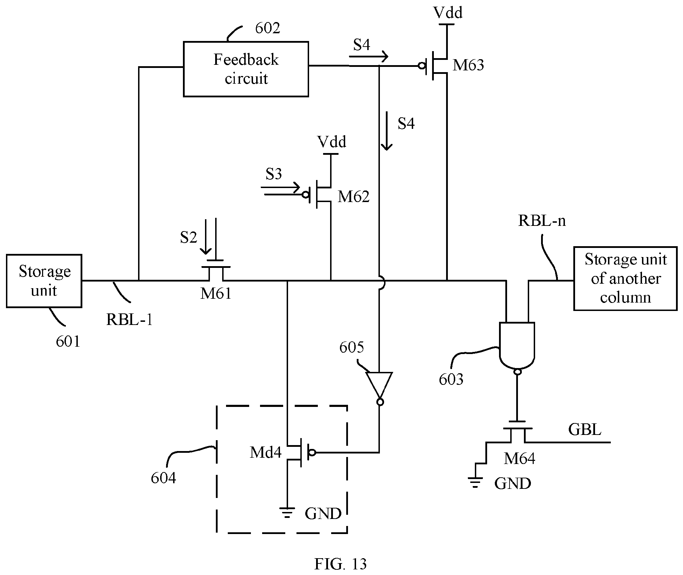

Specifically, FIG. 13 is a schematic diagram of a structure of a single-ended memory according to an embodiment of this application. Another specific structure of the discharge unit 604 is shown in detail in the single-ended memory shown in FIG. 13. The discharge unit 604 includes a transistor Md4 (namely, the foregoing ninth transistor, where a P-type transistor is used as an example of the transistor Md4). The single-ended memory further includes a NOT gate 605 (namely, the foregoing second NOT gate), where the control end of the transistor M63 (namely, the foregoing leakage current compensation unit, where the P-type transistor is used as the example of the transistor M63) is connected to an input end of the NOT gate 605, an output end of the NOT gate 605 is connected to a control end of the transistor Md4, a second end of the transistor Md4 is connected to the ground GND, a first end of the transistor Md4 is connected to the second end of the transistor M61 (namely, the foregoing column selection unit, where an N-type transistor is used as the example of the transistor M61), and the first end of the transistor M61 is connected to the read bit line RBL-1.

When the single-ended memory reads the storage information of the storage unit 601, the storage information is the high level, and the storage unit 601 outputs the high level to the read bit line RBL-1. When determining that the level of the read bit line RBL-1 is higher than the second predetermined value, the feedback circuit 602 outputs the feedback signal S4 to the control end of the transistor M63, where the feedback signal S4 is the low level, and the transistor M63 is conducted to control the power supply Vdd to charge the read bit line RBL-1 through the transistor M63, so that the read bit line RBL-1 remains at the high level. At the same time, the feedback signal S4 becomes the high level through a NOT operation of the NOT gate 605 and is input to the control end of the transistor Md4, the transistor Md4 is cut off, and the read bit line RBL-1 is not connected to the ground GND through the transistor Md4, to ensure that the read bit line RBL-1 remains at the high level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value, the feedback circuit 602 outputs the feedback signal S4 to the control end of the transistor M63, where the feedback signal S4 is the high level, and the transistor M63 is cut off, to stop the power supply Vdd from charging the read bit line RBL-1 through the transistor M63, so that the level of the read bit line RBL-1 continuously decreases to the low level. At the same time, the feedback signal S4 becomes the low level through the NOT gate 605 and is input to the control end of the transistor Md4, the transistor Md4 is conducted, and the read bit line RBL-1 is connected to the ground GND through the transistor Md4. However, because the transistor Md4 is the P-type transistor, there is a threshold loss during level transferring of the P-type transistor, which slows down the discharge speed of the discharge unit 604. If the level of the current read bit line RBL-1 decreases due to the leakage current, the discharge unit 604 disposed in this manner does not directly decrease the level of the read bit line RBL-1 to the low level, so that the read performance of the single-ended memory is more stable.

An embodiment of this application further provides a single-ended memory. In the single-ended memory, a second switch unit is further disposed between the first end of the discharge unit and the column selection unit.

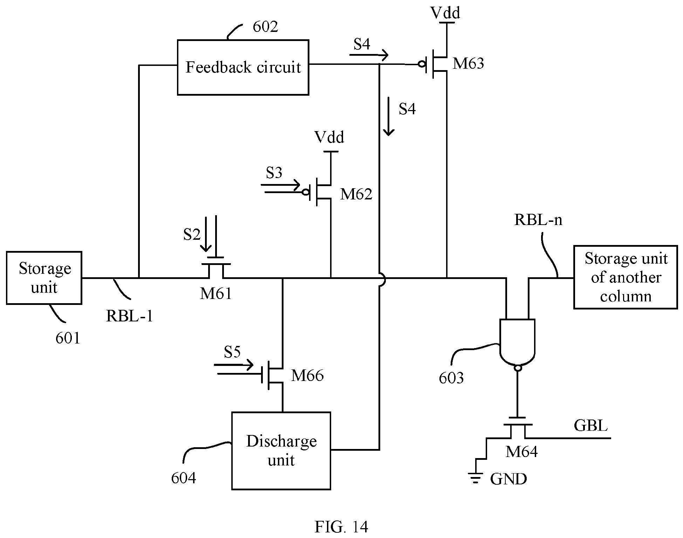

Specifically, FIG. 14 is a schematic diagram of a structure of a single-ended memory according to an embodiment of this application. The single-ended memory further includes a transistor M66 (namely, the foregoing second switch unit, where an N-type transistor is used as an example of the transistor M66). A first end of the discharge unit 604 is connected to a second end of the transistor M66, a first end of the transistor M66 is connected to the second end of the transistor M61 (namely, the foregoing column selection unit, where the N-type transistor is used as the example of the transistor M61), and the first end of the transistor M61 is connected to the read bit line RBL-1. A control end of the transistor M66 may be connected to a tracking (tracking) circuit of the single-ended memory, where the tracking circuit may track a level change of a global bit line GBL. Before the global bit line GBL reads the low level, the transistor M66 is conducted; and before the global bit line GBL reads the high level, the transistor M66 is cut off. Specifically, the high level may be output to the control end of the transistor M66 by a time amount of δt1 before the global bit line GBL reads the low level, to control the transistor M66 to be conducted. In this case, the discharge unit 604 is connected to the read bit line RBL-1 through the transistor M66 and the transistor M61, and the discharge unit 604 accelerates discharge of the read bit line RBL-1, so that the read bit line RBL-1 decreases to the low level more quickly. On the other hand, the low level may be output to the control end of the transistor M66 by a time amount of δt2 before the global bit line GBL reads the high level, to control the transistor M66 to be cut off. In this case, the discharge unit 604 cannot be connected to the read bit line RBL-1 through the transistor M66 and the transistor M61. If the level of the current read bit line RBL-1 decreases due to generation of a leakage current, the discharge unit 604 does not connect the read bit line RBL-1 to the ground to discharge the read bit line RBL-1, to ensure performance of the single-ended memory in reading the storage information being the high level. The time amount of δt1 and the time amount of δt2 may be configured by default or adaptively adjusted.

Alternatively, the control end of the transistor M66 may be connected to an external test pin of the single-ended memory. Specifically, when the storage information of the storage unit 601 is read, the external test pin may be configured to transmit the low level to control the transistor M66 to be cut off, so that the discharge unit 604 cannot be connected to the read bit line RBL-1 through the transistor M66 and the transistor M61. If the level of the current read bit line RBL-1 decreases due to the generation of the leakage current, the discharge unit 604 does not connect the read bit line RBL-1 to the ground to discharge the read bit line RBL-1, to ensure performance of the single-ended memory in reading the storage information being the high level. On the other hand, when the storage information of the storage unit 601 is read, the external test pin may be configured to transmit the high level to control the transistor M66 to be conducted, so that the discharge unit 604 is connected to the read bit line RBL-1 through the transistor M66 and the transistor M61, the discharge unit 604 accelerate discharge of the read bit line RBL-1, and the read bit line RBL-1 decreases to the low level more quickly.

In another embodiment, the control end of the discharge unit may be controlled to be connected or disconnected by using a circuit connection structure similar to that of the feedback circuit 602. For example, the single-ended memory further includes a second NOR gate and a third NOT gate.

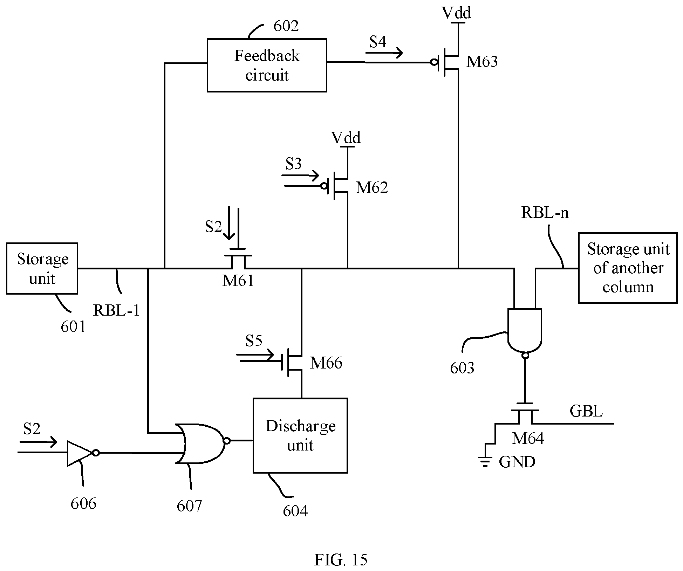

Specifically, FIG. 15 is a schematic diagram of a structure of a single-ended memory according to an embodiment of this application. The single-ended memory includes a NOT gate 606 (namely, the foregoing third NOT gate) and a NOR gate 607 (namely, the foregoing second NOR gate), where an input end of the NOT gate 606 is connected to the control end of the transistor M61 (namely, the foregoing column selection unit, where the N-type transistor is used as the example of the transistor M61), an output end of the NOT gate 606 is connected to a first input end of the NOR gate 607, a second input end of the NOR gate 607 is connected to the read bit line RBL-1, and an output end of the NOR gate 607 is connected to the control end of the discharge unit 604.

For example, as shown in FIG. 15, the input end of the NOT gate 606 is connected to the control end of the column selection unit. Specifically, it indicates that the column selection signal S2 is input to the control end of the transistor M61, and the column selection signal S2 is also input to the input end of the NOT gate 606.

When the single-ended memory reads the storage information of the storage unit 601, the storage information is the high level, and the storage unit 601 outputs the high level to the read bit line RBL-1. Although the level of the read bit line RBL-1 decreases due to the leakage current, when the level of the read bit line RBL-1 is between the second predetermined value and the high level, a level input to the second input end of the NOR gate 607 is considered to be the high level. Because the column selection signal S2 is the high level when reading occurs, a level of the column selection signal S2 output to the first input end of the NOR gate 607 through the NOT gate 606 is the low level, and the NOR gate 607 performs a NOR operation, so that a level transmitted to the control end of the discharge unit 604 by the NOR gate 607 is the low level.

When the single-ended memory reads the storage information of the storage unit 601, the storage information is the low level, and the storage unit 601 outputs the low level to the read bit line RBL-1, the level of the read bit line RBL-1 starts to decrease. When the level of the read bit line RBL-1 decreases to the first predetermined value, a level input to the second input end of the NOR gate 607 is considered to be the low level. Because the column selection signal S2 is the high level when reading occurs, the level of the column selection signal S2 output to the first input end of the NOR gate 607 through the NOT gate 606 is the low level, and the NOR gate 607 performs the NOR operation, so that the level transmitted to the control end of the discharge unit 604 by the NOR gate 607 is the high level.

It should be noted that, when the NOR gate 607 transmits the low level to the control end of the discharge unit 604, a transistor (the P-type transistor disposed in the discharge unit 604) in the discharge unit 604 may be controlled to be conducted to perform discharge, or a transistor (the N-type transistor disposed in the discharge unit 604) in the discharge unit 604 may be controlled to be cut off and not to perform discharge. When the NOR gate 607 transmits the high level to the control end of the discharge unit 604, the transistor (the N-type transistor disposed in the discharge unit 604) in the discharge unit 604 may be controlled to be conducted to perform discharge, or the transistor (the P-type transistor disposed in the discharge unit 604) in the discharge unit 604 may be controlled to be cut off and not to perform discharge.

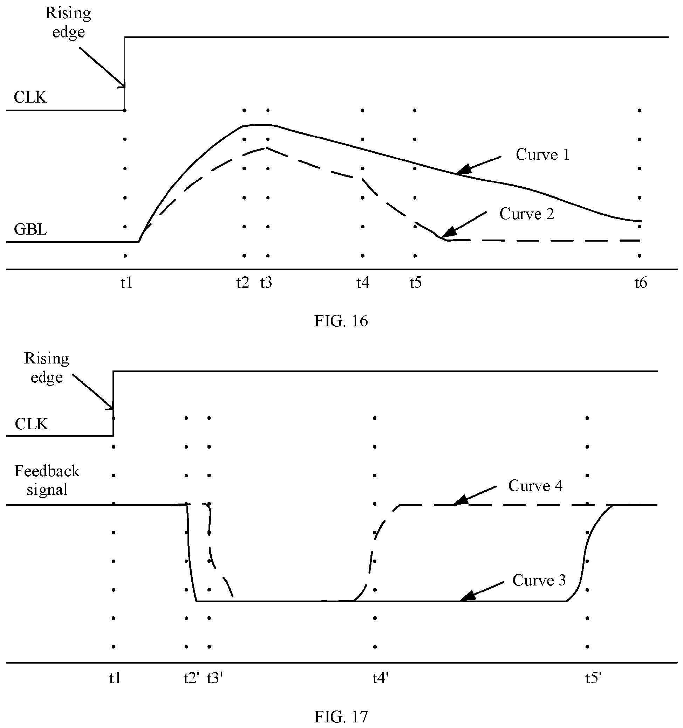

For example, when the feedback circuit 602 of the single-ended memory includes an inverter, and the discharge unit 604 is disposed, a slow-NOMS/fast-PMOS corner (slow-NMOS/fast-PMOS corner, SNFP corner) is selected, a level is set to 0.6 volts, and a temperature is set to -40 degrees Celsius; or a typical corner (typical corner, TT corner) is selected, a level is set to 1.2 volts, and a temperature is set to 25 degrees Celsius, to simulate the feedback signal and read time of the single-ended memory. Simulation diagrams are shown in FIG. 16 and FIG. 17.

It should be noted that, in the foregoing embodiments, a change process of increasing the level to the high level or decreasing the level to the low level is gradually changed. In the simulation diagram, because a set time interval is very short, the gradual change process is obvious.

Simulation is performed by using the read storage information of the storage unit being the low level, to obtain a level change (a curve 1) of a global bit line GBL in a conventional single-ended memory shown in FIG. 16 and a level change (a curve 2) of a global bit line GBL in the single-ended memory provided in embodiments of this application. Specifically, with reference to the curve 1 and FIG. 5, a process of reading storage information (a low level) of a storage unit in the conventional single-ended memory is described as follows. When a rising edge (that is, the CLK clock is just starting to be a high level) of a CLK clock arrives, the read bit line RBL-1 is selected. At a moment t1, the precharge unit M41 is turned on, and the precharge unit M41 charges the read bit line RBL-1. In addition, levels of the another read bit line RBL-n and the global bit line GBL continuously increase. In other words, from the moment t1 to a moment t2 of the curve 1, the level of the global bit line GBL continuously increases to the high level. Then, the storage unit c1 is selected by the read word line, and the storage unit c1 outputs storage information that is the low level to the read bit line RBL-1. The storage information that is the low level enables the level of the read bit line RBL-1 to continuously decrease. However, before the level of the read bit line RBL-1 decreases to the low level, the level of the read bit line RBL-1 received by the first end of the NAND gate 401 is the high level. The level of the another read bit line RBL-n received by the second end of the NAND gate 401 is the high level, and the NAND gate 401 performs the NAND operation to output the low level, so that the level of the control end of the transistor M42 is the low level, the transistor M42 is conducted, the read bit line RBL-1 is connected to the power supply Vdd through the transistor M42, the power supply Vdd charges the read bit line RBL-1, and the level of the read bit line RBL-1 decreases slowly. Refer to the moment t2 to a moment t3 of the curve 1. Because the level of the read bit line decreases slowly and does not decrease to the low level, the level output by the NAND gate 401 is the low level, the transistor M45 is cut off, and the global bit line GBL cannot be connected to the ground through the transistor M45. Therefore, the level of the global bit line GBL remains at the high level for a period of time from the moment t2 to the moment t3. When the level of the read bit line RBL-1 decreases to the low level, the NAND gate 401 performs the NAND operation to output the high level, the transistor M42 is cut off and the transistor M45 is conducted, and the global bit line GBL is connected to the ground through the transistor M45. In this way, the level of the global bit line GBL continuously decreases, that is, from the moment t3 to a moment t6, the global bit line GBL continuously decreases to the low level. An input/output circuit coupled to the global bit line GBL may determine that the level of the current global bit line GBL is the low level, and may also determine that the storage information of the current storage unit c1 is the low level.

In addition, with reference to the curve 2 and FIG. 15, a process of reading storage information (a low level) of a storage unit in a single-ended memory according to an embodiment of this application is described as follows. Refer to the curve 2 of FIG. 16 and the single-ended memory shown in FIG. 15. When the rising edge (that is, the CLK clock is just starting to be the high level) of the CLK clock arrives, the column selection unit M61 is turned on, and the read bit line RBL-1 is selected. At the moment t1, the precharge unit M62 is turned on, the precharge unit M62 charges the read bit line RBL-1, and the level of the read bit line RBL-1 continuously increases. In addition, the levels of the another read bit line RBL-n and the global bit line GBL also continuously increase. In other words, from the moment t1 to the moment t3 of the curve 1, the level of the global bit line GBL continuously increase to the high level. When determining that the level of the read bit line RBL-1 is higher than the second predetermined value, the feedback circuit 602 outputs the feedback signal to the control end of the leakage current compensation unit M63, to control the leakage current compensation unit M63 to charge the read bit line RBL-1 through the output end, so that the read bit line RBL-1 remains at the high level. At the moment t3, the storage unit 601 is selected by the read word line RWL, and the storage unit 601 outputs the storage information to the read bit line RBL-1. The storage information is the low level so that the level of the read bit line RBL-1 starts to decrease. Because the leakage current compensation unit M63 is not turned off at this time, the leakage current compensation unit M63 is still charging the read bit line RBL-1. In this case, the level of the read bit line RBL-1 decreases slowly. When determining that the level of the read bit line RBL-1 is lower than the first predetermined value, the feedback circuit 602 outputs the feedback signal to the control end of the leakage current compensation unit M63 to stop the leakage current compensation unit M63 from charging the read bit line RBL-1 through the output end. In this case, the level of the read bit line RBL-1 decreases quickly, and when the level of the read bit line RBL-1 decreases to the low level, the NAND gate 603 performs the NAND operation, the transistor M64 is conducted, and the global bit line GBL is connected to the ground through the transistor M64. In this way, the level of the global bit line GBL continuously decreases, that is, the global bit line GBL continuously decreases from the moment t3 to a moment t5. At a moment t4, because the discharge unit 604 is turned on, the level of the read bit line RBL-1 starts to decrease quickly, and it can be seen that the level of the global bit line GBL (namely, the curve 2) decreases significantly at the moment t4. The input/output circuit coupled to the global bit line GBL may determine that the level of the global bit line GBL is the low level at the moment t5, and may also determine that the storage information of the current storage unit 601 is the low level.

Refer to FIG. 16. It may be learned that in the conventional single-ended memory, duration consumed from a moment when the rising edge of the CLK clock arrives to a moment when the global bit line GBL reads that the storage information is the low level is t6-t1, which is 1.4 nanoseconds (the duration is reading time). However, in the single-ended memory provided in embodiments of this application, duration consumed from a moment when the rising edge of the CLK clock arrives to a moment when the global bit line GBL reads that the storage information is the low level is t5-t1, which is 0.8 nanoseconds (the duration is reading time). Compared with that of the conventional single-ended memory, the reading time of the single-ended memory provided in embodiments of this application is reduced by 40%.

FIG. 17 shows a level change (a curve 3) of a feedback signal received by a leakage current compensation unit in a conventional single-ended memory, and a level change (a curve 4) of a feedback signal received by a leakage current compensation unit in a single-ended memory according to an embodiment of this application. Specifically, with reference to the curve 3 and FIG. 5, a process of reading storage information (a low level) of a storage unit in the conventional single-ended memory is described as follows. When a rising edge (that is, a CLK clock is just starting to be a high level) of the CLK clock arrives, the read bit line RBL-1 is selected, the precharge unit M41 is turned on at the moment t1, and the precharge unit M41 charges the read bit line RBL-1, so that the level of the read bit line RBL-1 continuously increases. In addition, the levels of the another read bit line RBL-n and the global bit line GBL also continuously increase, the level of the read bit line RBL-1 received by the first end of the NAND gate 401 is the high level, the level of the another read bit line RBL-n received by the second end of the NAND gate 401 is the high level, and the NAND gate 401 performs the NAND operation to output the low level. In this case, the level (that is, the feedback signal received by the transistor M42) of the control end of the transistor M42 is the low level, and the transistor M42 is conducted. In other words, at a moment t2', the feedback signal output by the NAND gate 401 to the control end of the transistor M42 is the low level, to control the transistor M42 to be conducted, and the power supply Vdd charges the read bit line RBL-1 through the transistor M42. Therefore, the level of the feedback signal shown in curve 3 decreases quickly at the moment t2'. At a moment t5', the level of the read bit line RBL-1 decreases to the low level, the level of the read bit line RBL-1 received by the first end of the NAND gate 401 is the low level, the level of the another read bit line RBL-n received by the second end of the NAND gate 401 is the high level, and the NAND gate 401 performs the NAND operation to output the high level. In other words, with reference to the curve 3, at the moment t5, the NAND gate 401 outputs the feedback signal to the control end of the transistor M42, and the feedback signal is the high level and controls the transistor M42 to be cut off. In addition, the NAND gate 401 outputs the high level to enable the transistor M45 to be conducted, so that the global bit line GBL starts to perform discharge through the transistor M45, and the level of the global bit line GBL decreases. When the level of the global bit line GBL decreases to the low level, the input/output circuit coupled to the global bit line GBL may determine that the storage information of the storage unit c1 is the low level.

In addition, with reference to the curve 4 and FIG. 15, the process of reading the storage information (the low level) of the storage unit in the single-ended memory according to an embodiment of this application is described as follows. Refer to the curve 4 of FIG. 17 and the single-ended memory shown in FIG. 15. When the rising edge (that is, the CLK clock is just starting to be the high level) of the CLK clock arrives, the column selection unit M61 is turned on, and the read bit line RBL-1 is selected. At the moment t1, the precharge unit M62 is turned on, and the precharge unit M62 charges the read bit line RBL-1. In a process in which the read bit line RBL-1 is charged, when determining that the level of the read bit line RBL-1 is higher than the second predetermined value, the feedback circuit 602 outputs the feedback signal to the control end of the leakage current compensation unit M63, and the feedback signal is the low level as shown in the curve 4. In other words, at a moment t3', the feedback signal becomes the low level to control the leakage current compensation unit M63 to charge the read bit line RBL-1 through the output end. When the storage unit 601 is selected by the read word line RWL, the storage unit 601 outputs storage information to the read bit line RBL-1, and the storage information is the low level so that the level of the read bit line RBL-1 starts to decrease. When determining that the level of the read bit line RBL-1 is lower than the first predetermined value, the feedback circuit 602 outputs the feedback signal to the control end of the leakage current compensation unit M63, and the feedback signal is the high level as shown in curve 4. In other words, at a moment t4', the feedback signal becomes the high level to stop the leakage current compensation unit M63 from charging the read bit line RBL-1 through the output end. At this time, the level of the read bit line RBL-1 decreases faster, and due to the discharge unit 604, the level of the read bit line RBL-1 quickly decreases to the low level. The NAND gate 603 performs the NAND operation and outputs the high level, the transistor M64 is conducted, the global bit line GBL is connected to the ground through the transistor M64, the level of the global bit line GBL decreases, and the input/output circuit coupled to the global bit line GBL reads that the storage information of the storage unit 601 is the low level.

Refer to FIG. 17. It can be learned that, in the conventional single-ended memory, when the rising edge of the CLK clock arrives, the feedback signal changes from the high level to the low level and then to the high level, and consumed duration is t5'-t1, which is 1.47 nanoseconds. However, in the single-ended memory provided in embodiments of this application, when the rising edge of the clock of the column selection signal arrives, the feedback signal changes from the high level to the low level and then to the high level, and consumed duration is t4'-t1, which is 1.01 nanoseconds. Compared with that of the conventional single-ended memory, feedback signal change time of the single-ended memory provided in embodiments of this application is reduced by 46%. Compared with that of the conventional single-ended memory, the feedback signal of the single-ended memory provided in embodiments of this application may change to the high level earlier.

It should be noted that, to clearly describe embodiments provided in this application, types of transistors used in embodiments of this application are all shown. It may be understood that, without departing from an idea of this application by a person skilled in the art, the types of the transistors provided in embodiments of this application may be adaptively changed, and corresponding levels of control ends of the transistors may also be adaptively changed. Such changes are considered to be within the protection scope of this application.

## Claims

1. A single-ended memory, comprising: a storage unit (601) distributed in an array, wherein the storage unit (601) is connected to a read bit line (RBL) and a read word line (RWL), the read bit line (RBL) is connected to a precharge unit (M41) through a column selection unit (M61), the read bit line (RBL) is connected to an output end of a leakage current compensation unit (M63) through the column selection unit (M61), and the read bit line (RBL) is further connected to a control end of the leakage current compensation unit (M63) through a feedback circuit (602); and
when determining that a level of the read bit line (RBL) is lower than a first predetermined value, the feedback circuit (602) outputs a feedback signal to the control end of the leakage current compensation unit (M63), to stop the leakage current compensation unit (M61) from charging the read bit line (RBL) through the output end,
wherein the single-ended memory further comprises a discharge unit (604), wherein a control end of the discharge unit (604) is connected to the control end of the leakage current compensation unit (M63); and
a first end of the discharge unit (604) is connected to the read bit line (RBL) through the column selection unit (M61), and a second end of the discharge unit (604) is connected to the ground.

2. The single-ended memory according to claim 1, wherein
when determining that the level of the read bit line is higher than a second predetermined value, the feedback circuit (602) outputs a feedback signal to the control end of the leakage current compensation unit (M61), to control the leakage current compensation unit (M61) to charge the read bit line (RBL) through the output end, wherein the first predetermined value is less than or equal to the second predetermined value.

3. The single-ended memory according to claim 1 or 2, wherein the feedback circuit (602) comprises an inverter;
an input end of the inverter is connected to the read bit line (RBL), and an output end of the inverter is connected to the control end of the leakage current compensation unit (M61); and
the inverter is configured to generate a feedback signal based on the level of the read bit line (RBL).

4. The single-ended memory according to claim 3, wherein the inverter comprises a first transistor and a second transistor, wherein
a first end of the first transistor is connected to a power supply, a second end of the first transistor is connected to a first end of the second transistor, a second end of the second transistor is connected to the ground, a control end of the first transistor and a control end of the second transistor are connected to the input end of the inverter, and the second end of the first transistor is further connected to the output end of the inverter; and
types of the first transistor and the second transistor are different.

5. The single-ended memory according to claim 3, wherein the inverter comprises a third transistor, a fourth transistor, a fifth transistor, and a sixth transistor, wherein
a first end of the third transistor is connected to a power supply, a second end of the third transistor is connected to a first end of the fourth transistor, a second end of the fourth transistor is connected to a first end of the fifth transistor, a second end of the fifth transistor is connected to the ground, a first end of the sixth transistor is connected to the second end of the fourth transistor, a control end of the sixth transistor is connected to the second end of the third transistor, and a second end of the sixth transistor is connected to the power supply;
a control end of the third transistor, a control end of the fourth transistor, and a control end of the fifth transistor are connected to the input end of the inverter, and the second end of the third transistor is further connected to the output end of the inverter; and
types of the fourth transistor, the fifth transistor, and the sixth transistor are the same, and types of the third transistor and the fourth transistor are different.

6. The single-ended memory according to claim 1 or 2, wherein the feedback circuit (602) comprises a first NOR gate and a first NOT gate, wherein
an input end of the first NOT gate is connected to a control end of the column selection unit (M61), and an output end of the first NOT gate is connected to a first input end of the first NOR gate; and
a second input end of the first NOR gate is connected to the read bit line, and an output end of the first NOR gate is connected to the control end of the leakage current compensation unit (M63).

7. The single-ended memory according to any one of claims 1 to 6, wherein
after the precharge unit charges the read bit line (RBL) through the column selection unit (M61), if the read word line (RWL) selects the storage unit (601), the storage unit (601) outputs storage information to the read bit line (RBL).

8. The single-ended memory according to any one of claims 1 to 6, wherein
the feedback circuit (602) is connected to a transmission path between the storage unit (601) and the column selection unit (M61).

9. The single-ended memory according to any one of claims 1 to 8, wherein the single-ended memory further comprises a first switch unit, the leakage current compensation unit is connected to the read bit line through the first switch unit, and a control end of the first switch unit is connected to the control end of the column selection unit.

10. The single-ended memory according to any of the claims 1 to 9, wherein the discharge unit (604) comprises a seventh transistor and an eighth transistor, wherein
a control end of the seventh transistor is connected to the control end of the leakage current compensation unit (M63), and a first end of the seventh transistor is connected to the read bit line (RBL) through the column selection unit (M61), a second end of the seventh transistor is connected to a control end of the eighth transistor, the second end of the seventh transistor is further connected to a first end of the eighth transistor, and a second end of the eighth transistor is connected to the ground.

11. The single-ended memory according to any of the claims 1 to 9, wherein the discharge unit (604) comprises a ninth transistor, wherein the control end of the leakage current compensation unit is connected to a control end of the ninth transistor through a second NOT gate, a first end of the ninth transistor is connected to the read bit line (RBL) through the column selection unit, and a second end of the ninth transistor is connected to the ground.

12. The single-ended memory according to any one of claims 1 to 11, wherein a second switch unit is further disposed between the first end of the discharge unit (604) and the column selection unit (M61).

13. The single-ended memory according to any of the claims 1 to 12, wherein the single-ended memory further comprises a second NOR gate and a third NOT gate, wherein
an input end of the third NOT gate is connected to the control end of the column selection unit (M61), and an output end of the third NOT gate is connected to a first input end of the second NOR gate; and
a second input end of the second NOR gate is connected to the read bit line (RBL), and an output end of the second NOR gate is connected to the control end of the discharge unit (604).

## Patentansprüche

1. "Single-Ended"-Speicher, umfassend: eine Speichereinheit (601), die in einer Anordnung verteilt ist, wobei die Speichereinheit (601) mit einer Lese-Bitleitung (RBL) und einer Lese-Wortleitung (RWL) verbunden ist, die Lese-Bitleitung (RBL) mit einer Vorladeeinheit (M41) durch eine Spaltenauswahleinheit (M61) verbunden ist, die Lese-Bitleitung (RBL) mit einem Ausgangsende einer Leckstrom-Kompensationseinheit (M63) durch die Spaltenauswahleinheit (M61) verbunden ist und die Lese-Bitleitung (RBL) ferner mit einem Steuerende der Leckstrom-Kompensationseinheit (M63) durch eine Rückmeldungsschaltung (602) verbunden ist; und
wenn bestimmt wird, dass ein Pegel der Lese-Bitleitung (RBL) niedriger als ein erster im Voraus bestimmter Wert ist, gibt die Rückmeldungsschaltung (602) ein Rückmeldungssignal an das Steuerende der Leckstrom-Kompensationseinheit (M63) aus, um die Leckstrom-Kompensationseinheit (M61) zu stoppen, die Lese-Bitleitung (RBL) durch das Ausgangsende aufzuladen,
wobei der "Single-Ended"-Speicher ferner eine Entladeeinheit (604) umfasst, wobei ein Steuerende der Entladeeinheit (604) mit dem Steuerende der Leckstrom-Kompensationseinheit (M63) verbunden ist; und
ein erstes Ende der Entladeeinheit (604) mit der Lese-Bitleitung (RBL) durch die Spaltenauswahleinheit (M61) verbunden ist und ein zweites Ende der Entladeeinheit (604) mit der Masse verbunden ist.

2. "Single-Ended"-Speicher nach Anspruch 1, wobei
wenn bestimmt wird, dass der Pegel der Lese-Bitleitung höher als ein zweiter im Voraus bestimmter Wert ist, die Rückmeldungsschaltung (602) ein Rückmeldungssignal an das Steuerende der Leckstrom-Kompensationseinheit (M61) ausgibt, um die Leckstrom-Kompensationseinheit (M61) zu steuern, die Lese-Bitleitung (RBL) durch das Ausgangsende zu laden, wobei der erste im Voraus bestimmte Wert kleiner als der oder gleich dem zweiten im Voraus bestimmten Wert ist.

3. "Single-Ended"-Speicher nach Anspruch 1 oder 2, wobei die Rückmeldungsschaltung (602) einen Wechselrichter umfasst;
ein Eingangsende des Wechselrichters mit der Lese-Bitleitung (RBL) verbunden ist und ein Ausgangsende des Wechselrichters mit dem Steuerende der Leckstrom-Kompensationseinheit (M61) verbunden ist; und
der Wechselrichter konfiguriert ist, ein Rückmeldungssignal basierend auf dem Pegel der Lese-Bitleitung (RBL) zu erzeugen.

4. "Single-Ended"-Speicher nach Anspruch 3, wobei der Wechselrichter einen ersten Transistor und einen zweiten Transistor umfasst, wobei
ein erstes Ende des ersten Transistors mit einer Leistungsversorgung verbunden ist, ein zweites Ende des ersten Transistors mit einem ersten Ende des zweiten Transistors verbunden ist, ein zweites Ende des zweiten Transistors mit der Masse verbunden ist, ein Steuerende des ersten Transistors und ein Steuerende des zweiten Transistors mit dem Eingangsende des Wechselrichters verbunden sind und das zweite Ende des ersten Transistors ferner mit dem Ausgangsende des Wechselrichters verbunden ist; und die Typen des ersten Transistors und des zweiten Transistors verschieden sind.

5. "Single-Ended"-Speicher nach Anspruch 3, wobei der Wechselrichter einen dritten Transistor, einen vierten Transistor, einen fünften Transistor und einen sechsten Transistor umfasst, wobei
ein erstes Ende des dritten Transistors mit einer Leistungsversorgung verbunden ist, ein zweites Ende des dritten Transistors mit einem ersten Ende des vierten Transistors verbunden ist, ein zweites Ende des vierten Transistors mit einem ersten Ende des fünften Transistors verbunden ist, ein zweites Ende des fünften Transistors mit der Masse verbunden ist, ein erstes Ende des sechsten Transistors mit dem zweiten Ende des vierten Transistors verbunden ist, ein Steuerende des sechsten Transistors mit dem zweiten Ende des dritten Transistors verbunden ist und ein zweites Ende des sechsten Transistors mit der Leistungsversorgung verbunden ist;
ein Steuerende des dritten Transistors, ein Steuerende des vierten Transistors und ein Steuerende des fünften Transistors mit dem Eingangsende des Wechselrichters verbunden sind und das zweite Ende des dritten Transistors ferner mit dem Ausgangsende des Wechselrichters verbunden ist; und
die Typen des vierten Transistors, des fünften Transistors und des sechsten Transistors die gleichen sind und die Typen des dritten Transistors und des vierten Transistors verschieden sind.

6. "Single-Ended"-Speicher nach Anspruch 1 oder 2, wobei die Rückmeldungsschaltung (602) ein erstes NOR-Gatter und ein erstes NOT-Gatter umfasst, wobei ein Eingangsende des ersten NOT-Gatters mit einem Steuerende der Spaltenauswahleinheit (M61) verbunden ist und ein Ausgangsende des ersten NOT-Gatters mit einem ersten Eingangsende des ersten NOR-Gatters verbunden ist; und ein zweites Eingangsende des ersten NOR-Gatters mit der Lese-Bitleitung verbunden ist und ein Ausgangsende des ersten NOR-Gatters mit dem Steuerende der Leckstrom-Kompensationseinheit (M63) verbunden ist.

7. "Single-Ended"-Speicher nach einem der Ansprüche 1 bis 6, wobei
wenn, nachdem die Vorladeeinheit die Lese-Bitleitung (RBL) durch die Spaltenauswahleinheit (M61) lädt, die Lese-Wortleitung (RWL) die Speichereinheit (601) auswählt, die Speichereinheit (601) Speicherinformationen an die Lese-Bitleitung (RBL) ausgibt.

8. "Single-Ended"-Speicher nach einem der Ansprüche 1 bis 6, wobei
die Rückmeldungsschaltung (602) mit einem Übertragungspfad zwischen der Speichereinheit (601) und der Spaltenauswahleinheit (M61) verbunden ist.

9. "Single-Ended"-Speicher nach einem der Ansprüche 1 bis 8, wobei der "Single-Ended"-Speicher ferner eine erste Schalteinheit umfasst, die Leckstrom-Kompensationseinheit mit der Lese-Bitleitung durch die erste Schalteinheit verbunden ist und ein Steuerende der ersten Schalteinheit mit dem Steuerende der Spaltenauswahleinheit verbunden ist.

10. "Single-Ended"-Speicher nach einem der Ansprüche 1 bis 9, wobei die Entladeeinheit (604) einen siebten Transistor und einen achten Transistor umfasst, wobei
ein Steuerende des siebten Transistors mit dem Steuerende der Leckstrom-Kompensationseinheit (M63) verbunden ist und ein erstes Ende des siebten Transistors mit der Lese-Bitleitung (RBL) durch die Spaltenauswahleinheit (M61) verbunden ist, ein zweites Ende des siebten Transistors mit einem Steuerende des achten Transistors verbunden ist, das zweite Ende des siebten Transistors ferner mit einem ersten Ende des achten Transistors verbunden ist und ein zweites Ende des achten Transistors mit der Masse verbunden ist.

11. "Single-Ended"-Speicher nach einem der Ansprüche 1 bis 9, wobei die Entladeeinheit (604) einen neunten Transistor umfasst, wobei das Steuerende der Leckstrom-Kompensationseinheit mit einem Steuerende des neunten Transistors durch ein zweites NOT-Gatter verbunden ist, ein erstes Ende des neunten Transistors mit der Lese-Bitleitung (RBL) durch die Spaltenauswahleinheit verbunden ist und ein zweites Ende des neunten Transistors mit der Masse verbunden ist.

12. "Single-Ended"-Speicher nach einem der Ansprüche 1 bis 11, wobei eine zweite Schalteinheit ferner zwischen dem ersten Ende der Entladeeinheit (604) und der Spaltenauswahleinheit (M61) angeordnet ist.

13. "Single-Ended"-Speicher nach einem der Ansprüche 1 bis 12, wobei der "Single-Ended"-Speicher ferner ein zweites NOR-Gatter und ein drittes NOT-Gatter umfasst, wobei
ein Eingangsende des dritten NOT-Gatters mit dem Steuerende der Spaltenauswahleinheit (M61) verbunden ist und ein Ausgangsende des dritten NOT-Gatters mit einem ersten Eingangsende des zweiten NOR-Gatters verbunden ist; und ein zweites Eingangsende des zweiten NOR-Gatters mit der Lese-Bitleitung (RBL) verbunden ist und ein Ausgangsende des zweiten NOR-Gatters mit dem Steuerende der Entladeeinheit (604) verbunden ist.

## Revendications

1. Mémoire asymétrique, comprenant une unité de stockage (601) distribuée dans une matrice, dans laquelle l'unité de stockage (601) est connectée à une ligne de bit de lecture (RBL) et une ligne de mot de lecture (RWL), la ligne de bit de lecture (RBL) est connectée à une unité de précharge (M41) par le biais d'une unité de sélection de colonne (M61), la ligne de bit de lecture (RBL) est connectée à une extrémité de sortie d'une unité de compensation de courant de fuite (M63) par le biais de l'unité de sélection de colonne (M61), et la ligne de bit de lecture (RBL) est connectée en outre à une extrémité de commande de l'unité de compensation de courant de fuite (M63) par le biais d'un circuit de rétroaction (602) ; et
lorsqu'il est déterminé qu'un niveau de la ligne de bit de lecture (RBL) est inférieur à une première valeur prédéterminée, le circuit de rétroaction (602) délivre un signal de rétroaction à l'extrémité de commande de l'unité de compensation de courant de fuite (M63), pour faire en sorte que l'unité de compensation de courant de fuite (M63) arrête de charger la ligne de bit de lecture (RBL) par le biais de l'extrémité de sortie,
la mémoire asymétrique comprenant en outre une unité de décharge (604), dans laquelle une extrémité de commande de l'unité de décharge (604) est connectée à l'extrémité de commande de l'unité de compensation de courant de fuite (M63) ; et une première extrémité de l'unité de décharge (604) est connectée à la ligne de bit de lecture (RBL) par le biais de l'unité de sélection de colonne (M61), et une seconde extrémité de l'unité de décharge (604) est connectée à la masse.

2. Mémoire asymétrique selon la revendication 1, dans laquelle
lorsqu'il est déterminé que le niveau de la ligne de bit de lecture est supérieur à une seconde valeur prédéterminée, le circuit de rétroaction (602) délivre un signal de rétroaction à l'extrémité de commande de l'unité de compensation de courant de fuite (M61), afin de commander à l'unité de compensation de courant de fuite (M61) de charger la ligne de bit de lecture (RBL) par le biais de l'extrémité de sortie, dans laquelle la première valeur prédéterminée est inférieure ou égale à la seconde valeur prédéterminée.

3. Mémoire asymétrique selon la revendication 1 ou 2, dans laquelle le circuit de rétroaction (602) comprends un inverseur ;
une extrémité d'entrée de l'inverseur est connectée à la ligne de bit de lecture (RBL), et une extrémité de sortie de l'inverseur est connectée à l'extrémité de commande de l'unité de compensation de courant de fuite (M61) ; et
l'inverseur est configuré pour générer un signal de rétroaction sur la base du niveau de la ligne de bit de lecture (RBL).

4. Mémoire asymétrique selon la revendication 3, dans laquelle l'inverseur comprend un premier transistor et un second transistor, dans laquelle
une première extrémité du premier transistor est connectée à une alimentation électrique, une seconde extrémité du premier transistor est connectée à une première extrémité du second transistor, une seconde extrémité du second transistor est connectée à la masse, une extrémité de commande du premier transistor et une extrémité de commande du second transistor sont connectées à l'extrémité d'entrée de l'inverseur, et la seconde extrémité du premier transistor est connectée en outre à l'extrémité de sortie de l'inverseur ; et
des types du premier transistor et du second transistor sont différents.

5. Mémoire asymétrique selon la revendication 3, dans laquelle l'inverseur comprend un troisième transistor, un quatrième transistor, un cinquième transistor, et un sixième transistor, dans laquelle
une première extrémité du troisième transistor est connectée à une alimentation électrique, une seconde extrémité du troisième transistor est connectée à une première extrémité du quatrième transistor, une seconde extrémité du quatrième transistor est connectée à une première extrémité du cinquième transistor, une seconde extrémité du cinquième transistor est connectée à la masse, une première extrémité du sixième transistor est connectée à la seconde extrémité du quatrième transistor, une extrémité de commande du sixième transistor est connectée à la seconde extrémité du troisième transistor, et une seconde extrémité du sixième transistor est connectée à l'alimentation électrique ;
une extrémité de commande du troisième transistor, une extrémité de commande du quatrième transistor, et une extrémité de commande du cinquième transistor sont connectées à l'extrémité d'entrée de l'inverseur, et la seconde extrémité du troisième transistor est connectée en outre à l'extrémité de sortie de l'inverseur ; et
des types des quatrième transistor, cinquième transistor et sixième transistor sont identiques, et des types des troisième transistor et quatrième transistor sont différents.

6. Mémoire asymétrique selon la revendication 1 ou 2, dans laquelle le circuit de rétroaction (602) comprend une première porte NON OU et une première porte NON, dans laquelle
une extrémité d'entrée de la première porte NON est connectée à une extrémité de commande de l'unité de sélection de colonne (M61), et une extrémité de sortie de la première porte NON est connectée à une première extrémité d'entrée de la première porte NON OU ; et
une seconde extrémité d'entrée de la première porte NON OU est connectée à la ligne de bit de lecture, et une extrémité de sortie de la première porte NON OU est connectée à l'extrémité de commande de l'unité de compensation de courant de fuite (M63).

7. Mémoire asymétrique selon l'une quelconque des revendications 1 à 6, dans laquelle après que l'unité de précharge charge la ligne de bit de lecture (RBL) par le biais de l'unité de sélection de colonne (M61), si la ligne de mot de lecture (RWL) sélectionne l'unité de stockage (601), l'unité de stockage (601) délivre des informations de stockage à la ligne de bit de lecture (RBL).

8. Mémoire asymétrique selon l'une quelconque des revendications 1 à 6, dans laquelle le circuit de rétroaction (602) est connecté à un chemin de transmission entre l'unité de stockage (601) et l'unité de sélection de colonne (M61).

9. Mémoire asymétrique selon l'une quelconque des revendications 1 à 8, la mémoire asymétrique comprenant en outre une première unité de commutation, l'unité de compensation de courant de fuite est connectée à la ligne de bit de lecture par le biais de la première unité de commutation, et une extrémité de commande de la première unité de commutation est connectée à l'extrémité de commande de l'unité de sélection de colonne.

10. Mémoire asymétrique selon l'une quelconque des revendications 1 à 9, dans laquelle l'unité de décharge (604) comprend un septième transistor et un huitième transistor, dans laquelle
une extrémité de commande du septième transistor est connectée à l'extrémité de commande de l'unité de compensation de courant de fuite (M63), et une première extrémité du septième transistor est connectée à la ligne de bit de lecture (RBL) par le biais de l'unité de sélection de colonne (M61), une seconde extrémité du septième transistor est connectée à une extrémité de commande du huitième transistor, la seconde extrémité du septième transistor est connectée en outre à une première extrémité du huitième transistor, et une seconde extrémité du huitième transistor est connectée à la masse.

11. Mémoire asymétrique selon l'une quelconque des revendications 1 à 9, dans laquelle l'unité de décharge comprend un neuvième transistor, dans lequel l'extrémité de commande de l'unité de compensation de courant de fuite est connectée à une extrémité de commande du neuvième transistor par le biais d'une seconde porte NON, une première extrémité du neuvième transistor est connectée à la ligne de bit de lecture (RBL) par le biais de l'unité de sélection de colonne, et une seconde extrémité du neuvième transistor est connectée à la masse.

12. Mémoire asymétrique selon l'une quelconque des revendications 1 à 11, dans laquelle une seconde unité de commutation est disposée en outre entre la première extrémité de l'unité de décharge (604) et l'unité de sélection de colonnes (M61).

13. Mémoire asymétrique selon l'une quelconque des revendications 1 à 12, la mémoire asymétrique comprenant en outre une seconde porte NON OU et une troisième porte NON, dans laquelle
Une extrémité d'entrée de la troisième porte NON est connectée à l'extrémité de commande de l'unité de sélection de colonne (M61), et une extrémité de sortie de la troisième porte NON est connectée à une première extrémité d'entrée de la seconde porte NON OU ; et
une seconde extrémité d'entrée de la seconde porte NON OU est connectée à la ligne de bit de lecture (RBL), et une extrémité de sortie de la seconde porte NON OU est connectée à l'extrémité de commande de l'unité de décharge (604).
